(19) Europäisches Patentamt / European Patent Office / Office européen des brevets

(11) **EP 4 499 765 B1**

(12) **EUROPEAN PATENT SPECIFICATION**


(45) Date of publication and mention of the grant of the patent:
**06.05.2026 Bulletin 2026/19**

(21) Application number: **23715096.6**

(22) Date of filing: **27.03.2023**

(51) International Patent Classification (IPC):
***C09G 1/02*** $^{(2006.01)}$ ***C09K 3/14*** $^{(2006.01)}$
***H01L 21/3105*** $^{(2006.01)}$

(52) Cooperative Patent Classification (CPC):
**C09G 1/02; C09K 3/1436; H10P 95/062**

(86) International application number:
**PCT/EP2023/057760**

(87) International publication number:
**WO 2023/186762 (05.10.2023 Gazette 2023/40)**


(54) **COMPOSITIONS AND METHODS FOR TUNGSTEN ETCHING INHIBITION**

ZUSAMMENSETZUNGEN UND VERFAHREN ZUR HEMMUNG VON WOLFRAMÄTZEN

COMPOSITIONS ET PROCÉDÉS D’INHIBITION DE GRAVURE DE TUNGSTÈNE


(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **31.03.2022 EP 22165903**

(43) Date of publication of application:
**05.02.2025 Bulletin 2025/06**



(73) Proprietor: **BASF SE**
**67056 Ludwigshafen am Rhein (DE)**

(72) Inventors:
- **CHAO, Ching Hsun**
  **Taoyuan City, 32853 (TW)**
- **TSAI, Tsung Yu**
  **Taoyuan City, 32853 (TW)**
- **CHEN, Yong Yu**
  **Taoyuan City, 32853 (TW)**
- **LAUTER, Michael**
  **67056 Ludwigshafen am Rhein (DE)**
- **WEI, Te Yu**
  **Taoyuan City, 32853 (TW)**

(74) Representative: **BASF IP Association**
**BASF SE**
**GBI - Z078**
**67056 Ludwigshafen (DE)**



(56) References cited:
**WO-A1-2019/139828 US-A1- 2019 211 227**



Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



EP 4 499 765 B1

## Description

### Technical Field

The presently claimed invention relates to compositions and methods for polishing dielectric. The presently claimed invention particularly relates to compositions and methods that provide high selectivity towards removal of dielectric versus tungsten.

### Background

Fabrication of Integrated circuits (ICs) is a multi-step process. The first steps (also called front-end-of-line or FEOL steps) involve the patterning of individual devices such as transistors (for example C-MOSFETs) by suitable techniques (such as photo-lithography or ion implant) on the semiconductor. This is followed by insertion of metal wires/plugs and insulating layers (such as dielectric) to interconnect the various devices (also called back-end-of-line or BEOL steps). With the continuous shrink of the feature size in the ultra-large-scale integrated circuits (ULSI) technology, multi-level interconnects need to be formed.

Metals such as tungsten, cobalt, ruthenium and copper are commonly employed as connects and the selection of specific metal is done on the basis of its position in the architecture. For instance, a common first metal interconnect (metal layer 0) is a tungsten plug inserted in a dielectric layer (such as silicon dioxide). On the other hand, during BEOL steps copper is the most commonly deposited metal, but for the lower interconnect levels (for e.g., metal layers 1 - 4) tungsten and cobalt are also commonly employed.

CMP (Chemical mechanical planarization) has been found to be the key enabling technology for multi-level interconnect formation, as it can initiate both local and global planarization and at the same time provide a good surface quality, in terms of an excellent mirror-like defect-free surface finish. Purely mechanical polishing or (fine) grinding will provide excellent planarization, but dull surfaces. On the other hand, purely chemical polishing (anisotropic etching) will provide only poor planarization results, but excellent mirror-like surface finish.

Herein, CMP utilizes the interplay of chemical and mechanical action to achieve the desired planarity and finish of the to-be-polished surfaces. Mechanical action is usually carried out by the interaction of the CMP composition comprising a finely dispersed abrasive and the polishing pad which is typically pressed onto the to-be-polished surface and mounted on a moving platen. In a typical CMP process step, a rotating wafer holder brings the to-be-polished wafer in contact with a polishing pad. The CMP composition is usually applied between the to-be-polished wafer and the polishing pad.

Typical CMP compositions or slurries comprise one or more abrasives (insoluble/dispersed) components along with soluble components. The chemical action is provided by said soluble components of the CMP composition. Commonly, for achieving metal CMP, the chemical components are commonly tailored by balancing a corroding component (for example an acid, base or oxidiser) with a suitable inhibitor. However, it is important that the soluble and insoluble components are compatible to ensure colloidal stability. Colloidally unstable solutions or agglomerates can damage the surface and fine structures on the wafer to be polished by scratching. Therefore, in order to achieve suitable planarization and surface quality, a precise selection of components and their concentrations would be necessary for obtaining a suitable CMP composition.

In addition, the properties (for example etching) of several or all of the above-mentioned metals might have to be considered, when a slurry is designed, depending on the integration scheme. For instance, when fabricating ICs involving tungsten (metal 0), CMP is employed to remove the metal and liner/barrier overburden until a planar metal 0 (or higher) layer is exposed.

U.S. 6,083,419 A, for instance, describes a CMP composition comprising a compound that is capable of etching tungsten, at least one inhibitor of tungsten etching, wherein the inhibitor of tungsten etching is a compound including at least one functional group selected from nitrogen containing heterocycles without nitrogen-hydrogen bonds, sulphides, oxazolidines or mixtures of functional groups in one compound.

In cases such as U.S. 6,083,419 A, since the intended end point for such applications is the dielectric (for e.g., silicon oxide layer obtained by CVD deposition with tetraethylorthosilicate or TEOS), state of art slurries are tailored to achieve high tungsten versus silicon oxide removal rate. US 2019/0211227 and US 2019/0211228, for instance, aim at achieving high selectivity of tungsten removal by employing surface-modified colloidal silica particles bearing a negative charge.

On the other hand, in order to enable new integration schemes, the selective removal of dielectric is highly desirable. US 8,492,277 provides methods for polishing involving use of a composition comprising acyclic organosulfonic acid to provide selectively high removal rates for silicon oxide and silicon nitride. Similar results were achieved by US 8,513,126 utilizing compositions comprising quaternary ammonium salts. However, in presence of metals such as tungsten and cobalt which are easily removed in acidic conditions, there is an unmet need for obtaining compositions and methods that allow removal of dielectric with high selectivity over tungsten and/or cobalt, while maintaining a high surface

quality.

Summary

Surprisingly, it was found that the compositions of the presently claimed invention as described hereinbelow provide surprisingly high selectivity towards removal of dielectric versus tungsten.

Accordingly, in one aspect of the presently claimed invention, a dielectric polishing composition comprising:

(A) surface - modified colloidal silica particles comprising a negatively - charged group on the surface of the particles, wherein the surface-modified colloidal silica particles have a negative charge,
a particle size of from 60 nm to 200 nm, and a zeta potential < -35 mV at a pH in the range of from 2.0 to ≤ 4.5;
(B) a first corrosion inhibitor selected from at least one guanidine derivative;
(C) a second corrosion inhibitor selected from polyacrylamides or polyacrylamide copolymers;
(D) at least one iron (III) oxidizer;
(E) at least one silicon oxide removal rate enhancer selected from phosphoric acid and salts thereof;
(F) at least one stabilizer; and
(G) an aqueous medium,

wherein the pH of the composition is in the range of from ≥ 2.0 to ≤ 4.5.

In another aspect, the presently claimed invention is directed to a process for the manufacture of a semiconductor device comprising the chemical mechanical polishing of a substrate (S) used in the semiconductor industry, substrate (S) comprises

(i) tungsten and/or
(ii) tungsten alloys; and
(iii) at least one dielectric layer selected from silicon, silicon oxide, silicon nitride, or low-k material.

in the presence of the composition as described herein.

In another aspect, the presently claimed invention is directed to the use of a composition described herein for polishing a substrate (S) comprising: (i) tungsten and/or (ii) tungsten alloys; and (iii) at least one dielectric layer.

The presently claimed invention is associated with at least one of the following objectives:

(1) The compositions and the methods of the presently claimed invention aim to provide selective removal of dielectric layer over other metals such as tungsten and/or cobalt.
(2) The compositions and the methods of the presently claimed invention aim at providing high silicon oxide ($SiO_2$) and silicon nitride (SiN) removal rates, while ensuring low W removal rates.
(3) The compositions and the methods of the presently claimed invention aims to prevent unwanted etching of tungsten during chemical mechanical polishing of tungsten-containing substrates.
(4) The compositions and the methods of the presently claimed invention aims to prevent unwanted etching of cobalt during chemical mechanical polishing of cobalt-containing substrates.
(5) The composition of the presently claimed invention aims to provide a stable formulation or dispersion, wherein no phase separation or agglomeration occurs.
(6) The composition of the presently claimed invention aims to provide suitable removal rates for the dielectric, while preventing unwanted surface defects and ensuring high surface quality.

Other objects, advantages and applications of the presently claimed invention will become apparent to those skilled in the art from the following detailed description.

Detailed description

The following detailed description is merely exemplary in nature and is not intended to limit the presently claimed invention or the application and uses of the presently claimed invention. Furthermore, there is no intention to be bound by any theory presented in the preceding technical field, background, summary or the following detailed description.

The terms "comprising", "comprises" and "comprised of" as used herein are synonymous with "including", "includes" or "containing", "contains", and are inclusive or open-ended and do not exclude additional, non-recited members, elements or method steps. It will be appreciated that the terms "comprising", "comprises" and "comprised of" as used herein comprise the terms "consisting of", "consists" and "consists of".

Furthermore, the terms "(a)", "(b)", "(c)", "(d)" etc. and the like in the description and in the claims, are used for

distinguishing between similar elements and not necessarily for describing a sequential or chronological order. It is to be understood that the terms so used are interchangeable under appropriate circumstances and that the embodiments of the presently claimed invention described herein are capable of operation in other sequences than described or illustrated herein. In case the terms "(A)", "(B)" and "(C)" or "(a)", "(b)", "(c)", "(d)", "(i)", "(ii)" etc. relate to steps of a method or use or assay there is no time or time interval coherence between the steps, that is, the steps may be carried out simultaneously or there may be time intervals of seconds, minutes, hours, days, weeks, months or even years between such steps, unless otherwise indicated in the application as set forth herein above or below.

In the following passages, different aspects of the presently claimed invention are defined in more detail. Each aspect so defined may be combined with any other aspect or aspects unless clearly indicated to the contrary. In particular, any feature indicated as being preferred or advantageous may be combined with any other feature or features indicated as being preferred or advantageous.

Reference throughout this specification to "one embodiment" or "an embodiment" or "preferred embodiment" means that a particular feature, structure or characteristic described in connection with the embodiment is included in at least one embodiment of the presently claimed invention. Thus, appearances of the phrases "in one embodiment" or "in an embodiment" or "in a preferred embodiment" in various places throughout this specification are not necessarily all referring to the same embodiment but may refer. Furthermore, the features, structures or characteristics may be combined in any suitable manner, as would be apparent to a person skilled in the art from this disclosure, in one or more embodiments. Furthermore, while some embodiments described herein include some, but not other features included in other embodiments, combinations of features of different embodiments are meant to be within the scope of the subject matter, and form different embodiments, as would be understood by those in the art. For example, in the appended claims, any of the claimed embodiments can be used in any combination.

Furthermore, the ranges defined throughout the specification include the end values as well, i.e. a range of 1 to 10 implies that both 1 and 10 are included in the range. For the avoidance of doubt, the applicant shall be entitled to any equivalents according to applicable law.

For the purposes of the presently claimed invention, '% by weight' or 'wt.% 'as used in the presently claimed invention is with respect to the total weight of the coating composition. Further, sum of wt.% of all the compounds, as described hereinbelow, in the respective component adds up to 100 wt.-%.

For the purposes of the presently claimed invention, substrate is defined as a semiconductor wafer made of silicon or similar semi-metals used for making micro-electronic devices.

For the purposes of the presently claimed invention, polishing or cleaning refers to chemico-mechanical removal of specific layers on the substrate during CMP process. Mechanical action is usually carried out by a polishing pad which is typically pressed onto the to-be-polished surface and mounted on a moving platen. In a typical CMP process step, a rotating wafer holder brings the to-be-polished wafer in contact with a polishing pad. The CMP composition is usually applied between the to-be-polished wafer and the polishing pad.

For the purposes of the presently claimed invention, a corrosion inhibitor is defined as a chemical compound forming a protective molecular layer on the surface of a metal.

For the purposes of the presently claimed invention, a stabilizer is defined as a chemical compound that forms soluble, complex molecules with iron (III) ions, inactivating the ions so that they cannot normally react with other elements or ions, (such as phosphate) to produce precipitates or scale. In absence of stabilizer, the unwanted interaction between iron (III) oxidizer and silicon -based composition, as presently claimed, was found to result in colloidal instability of compositions.

A lower dielectric constant can increase the frequency at which a circuit can operate. Dielectric materials with lower dielectric constant used in metallization of IC production (mainly BEOL) are called low k materials (dielectric constant k for example 3.5 or lower) or ultra low k materials (dielectric constant k for example 2.5 and lower). Several low-k materials are available under the trade name Black Diamond from Applied Materials (see in general also US 6,974,777 B2 or Hosali et.al., Analyzing damage from ultralow-k CMP, Solid State Technology, 48 (11) pg. 33, 2005). Detailed description of a method to produce low k materials and their deposition can be found in McClatchie et.al., Low Dielectric Constant Oxide Films Deposited Using CVD Techniques, DUMIC Conference Proceedings, (1998), page 311 ff. For the purposes of the presently claimed invention, a low-k material is a material having a k value (dielectric constant) of less than 3.5, preferably less than 3.0, more preferably less than 2.7. An ultra-low-k material Is a material having a k value (dielectric constant) of less than 2.4.

For the purposes of the presently claimed invention, "colloidal silica" refers to silicon dioxide that has been prepared by condensation polymerization of $Si(OH)_4$. The precursor $Si(OH)_4$ can be obtained, for example, by hydrolysis of high purity alkoxysilanes, or by acidification of aqueous silicate solutions. Such colloidal silica can be prepared in accordance with U.S. Pat. No. 5,230,833 or can be obtained as any of various commercially available products, such as the Fuso® PL-1, PL-2, and PL-3 products, and the Nalco 1050, 2327 and 2329 products, as well as other similar products available from DuPont, Bayer, Applied Research, Nissan Chemical, Nyacol and Clariant.

For the purposes of the presently claimed invention, the "particle size" and "mean particle size" are used

interchangeably. Mean particle size is defined as the $d_{50}$ value of the particle size distribution of the colloidal silica particles (A) in the aqueous medium (G).

For the purposes of the presently claimed invention, the mean particle size is measured for example using dynamic light scattering (DLS) or static light scattering (SLS) methods. These and other methods are well known in the art, see e.g. Kuntzsch, Timo; Witnik, Ulrike; Hollatz, Michael Stintz; Ripperger, Siegfried; Characterization of Slurries Used for Chemical-Mechanical Polishing (CMP) in the Semiconductor Industry; Chem. Eng. Technol; 26 (2003), volume 12, page 1235. To the result of such a measurement literature commonly refers to as secondary particle size. Under these methods DLS is a preferred method.

For the purposes of the presently claimed invention, for dynamic light scattering (DLS), typically a Malvern Zetasizer ZSP or Horiba LB-550 V (DLS, dynamic light scattering measurement) or any other such instrument is used. This technique measures the hydrodynamic diameter of the particles as they scatter a laser light source (for example $\lambda$ = 650 nm), detected at an angle of for example 90° or 173° to the incoming light. Variations in the intensity of the scattered light are due to the random Brownian motion of the particles as they move through the incident beam and are monitored as a function of time. Autocorrelation functions performed by the instrument as a function of delay time are used to extract decay constants; smaller particles move with higher velocity through the incident beam and correspond to faster decays.

For the purposes of the presently claimed invention, the decay constants are proportional to the diffusion coefficient, $D_t$, of the inorganic abrasive particle and are used to calculate particle size according to the Stokes-Einstein equation:

$$D_h = \frac{k_B T}{3\pi\eta D_t}$$

where the suspended particles are assumed to (1) have a spherical morphology and (2) be uniformly dispersed (i.e. not agglomerated) throughout the aqueous medium. This relationship is expected to hold true for particle dispersions that contain lower than 1% by weight of solids as there are no significant deviations in the viscosity of the aqueous dispersant, in which $\eta$ = 0.96 mPa•s (at T = 22 °C). The particle size distribution of the fumed or colloidal silica particle dispersion is usually measured in a plastic cuvette at 0.1 to 1.0 % solid concentration and dilution, if necessary, is carried out with the dispersion medium or ultra-pure water.

For the purposes of the presently claimed invention, the BET surface of the colloidal silica particles is determined according to DIN ISO 9277:2010-09. To the result of such a measurement literature commonly refers to as primary particle size.

For the purposes of the presently claimed invention, an oxidizing agent is defined as a chemical compound which can oxidize the to-be-polished substrate or one of its layers.

For the purposes of the presently claimed invention, a pH adjusting agent is defined as a compound which is added to the composition in order to have its pH value adjusted to the required value.

For the purposes of the presently claimed invention, the measurement techniques disclosed are well known to a person skilled in the art.

In an aspect of the presently claimed invention, a dielectric polishing composition comprising:

(A) surface - modified colloidal silica particles comprising a negatively - charged group on the surface of the particles, wherein the surface-modified colloidal silica particles have a negative charge,
a particle size of from 60 nm to 200 nm, and a zeta potential < -35 mV at a pH in the range of from ≥ 2.0 to ≤ 4.5; (B) a first corrosion inhibitor selected from at least one guanidine derivative;
(C) a second corrosion inhibitor selected from polyacrylamides or polyacrylamide copolymers;
(D) at least one iron (III) oxidizer;
(E) at least one silicon oxide removal rate enhancer selected from phosphoric acid and salts thereof;
(F) at least one stabilizer; and
(G) an aqueous medium,

wherein the pH of the composition is in the range of from ≥ 2.0 to ≤ 4.5.

The dielectric polishing composition of the present invention comprises the components (A), (B), (C), (D), (E), (F) and water and optionally further components as described below.

(A) Surface - modified colloidal silica particles

According to the presently claimed invention, the composition comprises a negatively - charged group on the surface of the particles, wherein the surface-modified colloidal silica particles have a negative charge, a particle size of

from 60 nm to 200 nm, and a zeta potential < -35 mV at a pH in the range of from ≥ 2.0 to ≤ 4.5.

Well known silica-selective compositions typically are known to utilize ceria, however, said abrasive is noted to result in unacceptable dull finish. Similar unwanted observation was noted when utilizing fumed silica.

Preferably, the surface-modified silica particles have a zeta potential < -36 mV, more preferably, < -37 mV, and most preferably < -38 mV, at a pH in the range of from ≥ 2.0 to ≤ 4.5.

Preferably, the surface-modified silica particles have a zeta potential > -50 mV, more preferably, > -45 mV, and most preferably > -40 mV, at a pH in the range of from ≥ 2.0 to ≤ 4.5.

Preferably, the surface-modified silica particles have a zeta potential of from -50 mV to -35 mV, more preferably of from -45 mV to -35 mV, even more preferably of from -40 mV to -35 mV, and most preferably of from -39 mV to -35 mV, at a pH in the range of from ≥ 2.0 to ≤ 4.5

The surface-modified silica particles are preferably amorphous and not agglomerated and thus typically occur in the form of discrete spheres that are not crosslinked with each other and contain hydroxyl groups on the surface. Surface-modified colloidal silica particles are obtainable by methods known in the art such as ion-exchange of silicic acid salt, or by sol-gel technique (e.g., hydrolysis or condensation of a metal alkoxide, or peptization of precipitated hydrated silicon oxide, etc.).

The silica particles are known to be stabilized by a permanent electrical charge on their surface to prevent agglomeration and to ensure colloidal stability. The charge can be positive or negative. Because of defects observed on surface when positively charged (or cationic) silica particles are employed (refer Figure 2b), a negative charge is considered as essential. This is depicted in the defect-free surface in Figure 2a, wherein the substrate was planarized with a composition comprising negatively charged (or anionic) silica particles. The charge on the surface is expressed by the zeta potential. The zeta potential of silica particles (not surface functionalized) depends on the pH value of the aqueous medium (refer Figure 1). At pH higher than 8 the zeta potential is equal or lower than - 35 mV, i.e., low enough to ensure colloidal stability. Without being bound by theory, it is believed that at acidic pH (for example pH 2-4), as a consequence of the interaction of the silica with the protons of the media, the charge on the surface is reduced (zeta potential typically for example between +10 and -10 mV). Typical correlation of zeta potential and pH can be found in the literature (Esumi et.al., Bull.Chem.Soc.Jpn., Vol. 61, 1988). Low surface charge can lead to formation of agglomerates as soon as shear forces (for example through filtration or polishing action) arise, as noted from the variation in zeta potential of refer unmodified silica particles in Figure 1.

Preferably the surface modified colloidal silica particles (A) having a negative zeta potential of < -35 mV at a pH in the range of from ≥ 2.0 to ≤ 4.5 are silica particles anionically modified with metallate ions or modified with sulfonic acid.

The term "anionically modified with metallate ions" as utilized herein in particular refers to silica particles where metallate ions (i.e., $M(OH)_4$) are incorporated in the surface of the silica particle replacing $Si(OH)_4$ sites and creating a permanent negative charge, as explained in WO 2006/028759 A2.

Preferably, the surface modified colloidal silica particles (A) having a negative zeta potential of < -35 mV at a pH in the range of from ≥ 2.0 to ≤ 4.5 are silica particles anionically modified with metallate ions. More preferably, the metallate ions are selected from aluminate, stannate, zincate, or plumbate.

Even more preferably, the surface modified colloidal silica particles (A) having a negative zeta potential of < -35 mV at a pH in the range of from ≥ 2.0 to ≤ 4.5 are silica particles anionically modified with aluminate. Such surface modified colloidal silica particles are disclosed e.g. in WO 2006/7028759 A2.

More preferably, the surface modified colloidal silica particles of component (A) having a negative zeta potential of < -35 mV at a pH in the range of from ≥ 2.0 to ≤ 4.5 are silica particles anionically modified with sulfonic acid. Sulfonic acid-modified aqueous anionic silica sols which are highly stable under acidic conditions are disclosed e.g. in WO 2010734542 A1. Herein, a sulfonic acid-modified aqueous anionic silica sol is obtained by a method wherein a silane coupling agent having a functional group which can be chemically converted into a sulfonic acid group is chemisorbed onto the colloidal silica, and then the functional group is converted into a sulfonic acid group. A preferred type of silica dispersion to be used for this type of chemical reaction is a silica dispersion with a zeta potential function like Figure 1 (unmodified silica particles), where the charge on the particle surface is low in the acidic regime. The same is identified as a sign that the surface of the silica is clean and the silane can easily react with the groups on the silica surface. If the charge on the silica particles before charging the reaction with the silane coupling agent in the acidic regime (for example pH 2-3) is already high (for example -36 or -50 mV) then it is interpreted as a sign that the silica surface is not clean and already modified. The silane coupling agent may not be able to cover the surface sufficiently and the charge on the surface subsequently after reaction and conversion may remain low. A surface modified particle dispersion with a zeta potential of for example -23 mV can have a low colloidal stability. This means that the dispersion can be easily destabilized by processes like filtration or CMP, where shear forces appear. In such a case, a filtered silica dispersion measured by DLS methods for example with a Malvern Zetasizer ZSP (refer Figure 3) will provide signal with high variation, that cannot be interpreted easily as a mean particle size. Other methods, like sedimentations methods, must be used here to assess colloidal stability. On the other hand, the silica particles anionically modified with sulfonic acid are noted to yield in a readily-measurable stable DLS signal (refer Figure 4).

Preferably, the concentration of the surface modified colloidal silica particles (A) is in the range of from ≥ 0.01 wt.% to ≤ 13.0 wt.%, based on the total weight of the composition.

The concentration of the surface modified colloidal silica particles (A) is preferably not more than 13.0 wt.%, more preferably not more than 10.0 wt.%, particularly not more than 8.0 wt.%, for example not more than 7.0 wt.%, based on the total weight of the composition. It is observed that particle concentration beyond 10 wt.% lead to colloidal instability of composition. The concentration of the surface modified colloidal silica particles (A) is preferably at least 0.01 wt.%, more preferably at least 0.1 wt.%, even more preferably at least 0.2 wt.%, particularly at least 0.3 wt.%, even more preferably at least 0.5 wt.%, still more preferably at least 0.8 wt.%, more preferably at least 1.0 wt.%, even more preferably at least 1.2 wt.%, still more preferably at least 1.5 wt.%, most preferably at least 1.8 wt.%, based on the total weight of the composition. The concentration of the surface modified colloidal silica particles (A) is more preferably in the range of from ≥ 0.3 wt.% to ≤ 7.0 wt.%, based on the total weight of the composition.

The surface modified colloidal silica particles (A) can be preferably contained in the composition in various particle size distributions. The particle size distribution of the surface modified colloidal silica particles (A) can be monomodal or multimodal. In case of a multimodal particle size distribution, a bimodal particle size distribution is often preferred. For the purposes of the presently claimed invention, a monomodal particle size distribution is preferred for the surface modified colloidal silica particles (A).

According to the presently claimed invention, the average particle diameter of the surface modified colloidal silica particles (A) is in the range of from 60 nm to 200 nm, determined according to dynamic light scattering technique.

The mean or average particle size of the surface modified colloidal silica particles (A) can vary within a wide range. The mean particle size of the surface modified colloidal silica particles (A) is preferably in the range of from ≥ 60 nm to ≤ 190 nm, preferably in the range of from ≥ 60 nm to ≤ 180 nm, more preferably in the range of from ≥ 62 nm to ≤ 150 nm, more preferably in the range of from ≥ 65 nm to ≤ 130 nm, particularly preferably in the range of from ≥ 70 nm to ≤ 120 nm, particularly most preferably in the range of from ≥80 nm to ≤100 nm, in each case measured with dynamic light scattering techniques using instruments for example a Zetasizer ZSP or a High Performance Particle Sizer (HPPS) from Malvern Instruments, Ltd. or Horiba LB550.

The at least one inorganic abrasive particle (A) preferably can be of various shapes. Thereby, the particles (A) may preferably be of one or essentially only one type of shape. However, it is also possible that the particles (A) have different shapes. For instance, two types of differently shaped particles (A) may be present. For example, (A) can have the shape of agglomerates, cubes, cubes with bevelled edges, octahedrons, icosahedrons, cocoons, nodules or spheres with or without protrusions or indentations.

Preferably, the surface modified colloidal silica particles (A) are spherical, cocoon-shaped or a mixture of spherical and cocoon-shaped particles. The spherical particles may be with or without protrusions or indentations. The cocoon-shaped particles may be with or without protrusions or indentations. Cocoon-shaped particles are preferably particles with a minor axis of from ≥10 nm to ≤200 nm, and preferably a ratio of major/minor axis of from ≥1.4 to ≤2.2, more preferably of from ≥1.6 to ≤2.0. Preferably, they have an averaged shape factor of from ≥ 0.7 to ≤0.97, more preferably of from ≥0.77 to ≤0.92, preferably an averaged sphericity of from ≥0.4 to ≤0.9, more preferably of from ≥0.5 to ≤0.7 and preferably an averaged equivalent circle diameter of from ≥41 nm to ≤66 nm, more preferably of from ≥48 nm to ≤60 nm, in each case determined by transmission electron microscopy and scanning electron microscopy.

Most preferably, the surface modified colloidal silica particles (A) are spherical or essentially spherical. The spherical or essentially spherical particles have a ratio of major/minor axis ≥ 0.9.

For the purposes of the presently claimed invention, the determination of the shape factor, the sphericity and the equivalent circle diameter of cocoon-shaped particles is explained hereinbelow. The shape factor gives information on the shape and the indentations of an individual particle and can be calculated according to the following formula:

$$\text{shape factor} = 4\pi\ (\text{area} / \text{perimeter2})$$

The shape factor of a spherical particle without indentations is 1. The value of the shape factor decreases when the number of indentations increases. The sphericity gives information on the elongation of an individual particle using the moment about the mean and can be calculated according to the following formula, wherein M are the centres of gravity of the respective particle:

$$\text{sphericity} = (\text{Mxx} - \text{Myy})\text{-}[4\ \text{Mxy2} + (\text{Myy-Mxx})2]0.5 / (\text{Mxx} - \text{Myy}) + [4\ \text{Mxy2} + (\text{Myy-Mxx})2]0.5$$

$$\text{elongation} = (1 / \text{sphericity})0.5$$

wherein

Mxx = Σ (x-xmean)$^2$ /N
Myy = Σ (y-ymean)$^2$ /N
Mxy = Σ [(x-xmean)*(y-ymean)] /N
N number of pixels forming the image of the respective particle
x, y coordinates of the pixels
xmean mean value of the x coordinates of the N pixels forming the image of said particle
ymean mean value of the y coordinates of the N pixels forming the image of said particle

The sphericity of a spherical particle is 1. The value of the sphericity decreases, when particles are elongated. The equivalent circle diameter (also abbreviated as ECD in the following) of an individual non-circular particle gives information on the diameter of a circle which has the same area as the respective non-circular particle. The averaged shape factor, averaged sphericity and averaged ECD are the arithmetic averages of the respective property, related to the analysed number of particles.

For the purposes of the presently claimed invention, the procedure for particle shape characterization is as follows. An aqueous cocoon-shaped silica particle dispersion with 20 wt.% solid content is dispersed on a carbon foil and is dried. The dried dispersion is analyzed by using Energy Filtered-Transmission Electron Microscopy (EF-TEM) (120 kilo volts) and Scanning Electron Microscopy secondary electron image (SEM-SE) (5 kilo volts). The EF-TEM image having a resolution of 2k, 16 Bit, 0.6851 nm/pixel is used for the analysis. The images are binary coded using the threshold after noise suppression. Afterwards, the particles are manually separated. Overlying and edge particles are discriminated and not used for the analysis. ECD, shape factor and sphericity as defined before are calculated and statistically classified.

(B) First corrosion inhibitor

According to the presently claimed invention, the composition comprises at least one first corrosion inhibitor selected from at least one guanidine derivative.

As may be observed from Table 1 hereinbelow, the first corrosion inhibitor selected from at least one guanidine derivative prevents unwanted corrosion of tungsten, while facilitating high dielectric removal rates (both silicon oxide and silicon nitride).

Preferably, the at least one guanidine derivative is selected from buformin, phenformin, guanine, proguanil hydrochloride, 2-guanidinobenzimidazole, polyhexamethylene biguanide hydrochloride, polyaminopropyl biguanide, arginine, chlorhexidine or chlorhexidine salts.

More preferably, guanidine derivative is selected from chlorhexidine or chlorhexidine salts. Chlorhexidine or salts thereof are known to degrade over prolonged period of time into chemical sub-species, however, the degradation is noted to have little or no impact on the CMP activity outlined herein. The concentrations of said products would vary with conditions (temperature/pressure etc.). Some of the likely degradation products as outlined in table II-1 on page 19 of thesis titled- Studies on the mechanisms of solid state and solution instability of drugs by Zhixin Zong are reproduced below. The manipulation of degradation products and/or their concentration to enhance activity would be considered routine for a skilled person.

| MW | Proposed Structure |
|---|---|
| 395 | 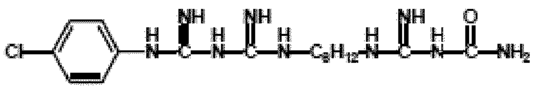 |
| 396 | 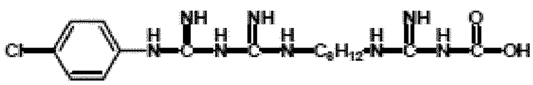 |
| 505 | 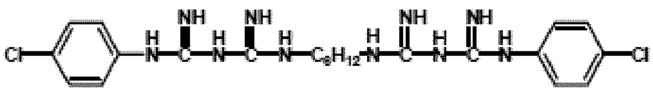 |
| 506 | 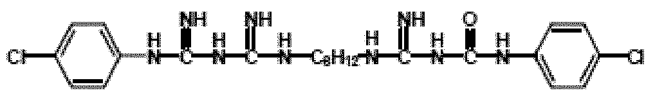 |
| 507 | 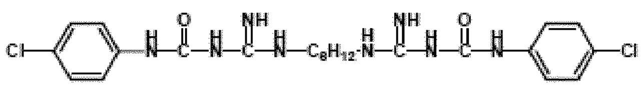 |

(continued)

| MW | Proposed Structure |
|---|---|
| 127 | 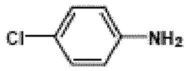 |
| 352 | 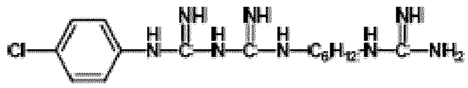 |
| 171 | 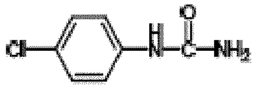 |

Preferably, the chlorhexidine or chlorhexidine salts include the degradation products listed hereinabove.
Preferably, the first corrosion inhibitor (B) is chlorohexidine.
Preferably, the first corrosion inhibitor (B) is selected from chlorohexidine salts.
More preferably, the chlorhexidine salts are selected from the group consisting of chlorhexidine gluconate, chlorhexidine digluconate, chlorhexidine hydrochloride, chlorhexidine dihydrochloride, chlorhexidine acetate, chlorhexidine diacetate, chlorhexidine hexametaphosphate, chlorhexidine metaphosphate and chlorhexidine trimetaphosphate.
Most preferably, the first corrosion inhibitor is selected from the group consisting of chlorhexidine, chlorhexidine gluconate, and chlorhexidine digluconate,
**[0073]** Preferably, the first corrosion inhibitor (B) is present in an amount in the range of from ≥ 0.005 wt.% to ≤ 0.05 wt.%, based on the total weight of the composition.
More preferably, the first corrosion inhibitor (B) is present in an amount of not more than 0.04 wt.%, most preferably not more than 0.03 wt.%, based on the total weight of the composition. The amount of (B) is preferably at least 0.008 wt.%, more preferably at least 0.01 wt.%, based on the total weight of the composition. The concentration of the corrosion inhibitor (B) is more preferably in the range of from ≥ 0.01 wt.% to ≤ 0.03 wt.%, based on the total weight of the composition.

(C) Second corrosion inhibitor

According to the presently claimed invention, the composition comprises at least one second corrosion inhibitor (C) selected from polyacrylamides and polyacrylamide copolymers.
As may be observed from Table 1 hereinbelow, the second corrosion inhibitor (C) selected from polyacrylamides and polyacrylamide copolymers prevents unwanted corrosion of tungsten, while ensuring high planarization or polishing efficiency. Absence of (C), for instance is noted to result in unwanted to topological defects (refer Example 18 in Table 1 hereinbelow).
Preferably, the polyacrylamide copolymers are anionic or non-ionic polyacrylamide copolymers. For the purposes of the presently claimed invention, the polyacrylamide copolymers are not selected from cationic polyacrylamide copolymers preferably. The use of cationic polyacrylamide copolymers in the composition may lead to flocculation and instability. Preferably, the amount of cationic polyacrylamide copolymers in the composition is < 0.01 wt%, based on the total weight of the composition.
Preferably, the polyacrylamide copolymers are non-ionic polyacrylamide copolymers.
More preferably, the polyacrylamides are homopolymers.
Preferably, the second corrosion inhibitor (C) is present in an amount in the range of from ≥ 0.005 wt.% to ≤ 0.02 wt.%, based on the total weight of the composition.
More preferably, the second corrosion inhibitor (C) is present in an amount of not more than 0.018 wt.%, even more preferably not more than 0.015 wt.%, most preferably not more than 0.012 wt.%, most preferably not more than 0.01 wt.%, based on the total weight of the composition. The amount of (C) is preferably at least 0.0051 wt.%, more preferably at least 0.0055 wt.%, most preferably at least 0.006 wt.%, based on the total weight of the composition. The concentration of the corrosion inhibitor (C) is more preferably in the range of from ≥ 0.0055 wt.% to ≤ 0.018 wt.%, most preferably is in the range of from ≥ 0.006 wt.% to ≤ 0.012 wt.%, based on the total weight of the composition.
Preferably, the weight average molecular weight of the second corrosion inhibitor (C) is in the range of from ≥ 5000 g/mol to ≤ 50,000 g/mol, determined according to gel permeation chromatography. More preferably, the weight average molecular weight of the second corrosion inhibitor (C) is in the range of from ≥ 5000 g/mol to ≤ 40,000 g/mol, determined according to gel permeation chromatography. Even more preferably, the weight average molecular weight of the second corrosion inhibitor (C) is in the range of from ≥ 7500 g/mol to ≤ 15,000 g/mol, determined according to gel

permeation chromatography.

(D) Iron (III) oxidizer

According to the presently claimed invention, the composition comprises at least one iron (III) oxidizer (D).

As may be observed from Table 1 hereinbelow, the iron (III) oxidizer (D) oxidizes the to-be-polished substrate or one of its layers, thus ensuring a chemical contribution to the removal rate and a high surface quality.

Preferably, the iron (III) oxidizer (D) is selected from iron (III) salts or compounds with nitric acid, sulfuric acid, hydrofluoric acid, hydrochloric acid, hydrobromic acid, hydroiodic acid, perchloric acid, perbromic acid, periodic acid, acetic acid, acetylacetonate, o-phosphorylethanolamine, phosphonic acid, alendronic acid, acetic acid, phthalic acid, citric acid, adipic acid, oxalic acid, malonic acid, aspartic acid, succinic acid, glutaric acid, pimelic acid, suberic acid, azelaic acid, sebacic acid, oxalic acid, maleic acid, gluconic acid, muconic acid, ethylenediaminetetraacetic acid, propylene diaminetetraacetic acid, or mixtures thereof.

More preferably, the iron (III) oxidizer (D) is selected from iron (III) nitrate or hydrates thereof. Even more preferably, the iron (III) oxidizer (D) is iron (III) nitrate.

Preferably, the concentration of the iron (III) oxidizer (D) is in the range of from ≥ 0.005 wt.% to ≤ 0.1 wt.%, based on the total weight of the composition.

More preferably, the iron (III) oxidizer (D) is present in an amount of not more than 0.08 wt.%, even more preferably not more than 0.07 wt.%, most preferably not more than 0.05 wt.%, most preferably not more than 0.03 wt.%, based on the total weight of the composition. The amount of (D) is preferably at least 0.0055 wt.%, more preferably at least 0.006 wt.%, most preferably at least 0.008 wt.%, based on the total weight of the composition. The concentration of the iron (III) oxidizer (D) is more preferably in the range of from ≥ 0.0055 wt.% to ≤ 0.008 wt.%, most preferably is in the range of from ≥ 0.008 wt.% to ≤ 0.03 wt.%, based on the total weight of the composition.

(E) Silicon oxide removal rate enhancer

According to the presently claimed invention, the composition comprises at least one silicon oxide removal rate enhancer (E) selected from phosphoric acid or salts thereof.

As may be observed from Table 1 hereinbelow, the silicon oxide removal rate enhancer (E) specifically ensures high silicon oxide removal rate.

Preferably, the at least one silicon oxide removal rate enhancer (E) is phosphoric acid or potassium salt of phosphoric acid. More preferably, the at least one silicon oxide removal rate enhancer (E) is dipotassium hydrogen phosphate.

Preferably, the concentration of the silicon oxide removal rate enhancer (E) is in the range of from ≥ 0. 1 wt.% to ≤ 1.0 wt.%, based on the total weight of the composition.

More preferably, the silicon oxide removal rate enhancer (E) is present in an amount of not more than 0.9 wt.%, even more preferably not more than 0.8 wt.%, most preferably not more than 0.65 wt.%, based on the total weight of the composition. The amount of (E) is preferably at least 0.15 wt.%, more preferably at least 0.2 wt.%, most preferably at least 0.35 wt.%, based on the total weight of the composition. The concentration of the silicon oxide removal rate enhancer (E) is more preferably in the range of from ≥ 0.15 wt.% to ≤ 0.9 wt.%, most preferably is in the range of from ≥ 0.35 wt.% to ≤ 0.65 wt.%, based on the total weight of the composition.

In a preferred embodiment the silicon oxide removal enhancer (E) is phosphoric acid and is present in amount of ≥ 0.15 wt.% to ≤ 0.9 wt.% based on the total weight of the composition.

In another preferred embodiment the silicon oxide removal enhancer (E) is dipotassium hydrogen phosphate and is present in amount of ≥ 0.15 wt.% to ≤ 0.9 wt.% based on the total weight of the composition

(F) Stabilizer

According to the presently claimed invention, the composition comprises at least one stabilizer (F).

Without being bound by theory, it is expected that agglomerate-formation is highly prevalent when employing incompatible components such as silica particles, iron (III) salts and phosphates. However, as may be observed from Table 1 hereinbelow, the stabilizer (F) ensures colloidal stability.

Preferably, the at least one stabilizer (F) is selected from acetic acid, acetylacetonate, o-phosphorylethanolamine, phosphonic acid, alendronic acid, acetic acid, phthalic acid, citric acid, adipic acid, oxalic acid, malonic acid, aspartic acid, succinic acid, glutaric acid, pimelic acid, suberic acid, azelaic acid, sebacic acid, oxalic acid, maleic acid, gluconic acid, muconic acid, ethylenediaminetetraacetic acid, propylene diaminetetraacetic acid, N,N-bis(carboxymethyl) alanine, nitrilo-triacetic acid, diethylene-triamine-pentaacetic acid, bis(salicyliden)ethylendiamin, aminotris(methylenephosphonic acid), diethylene-triamine-pentakis(methylphosphonic acid), ethylene-diamine-tetra(methylene-phosphonic acid), or

mixtures thereof.

More preferably, the at least one stabilizer (F) is selected from phthalic acid, citric acid, adipic acid, oxalic acid, aspartic acid, succinic acid, glutaric acid, pimelic acid, suberic acid, azelaic acid, sebacic acid, oxalic acid, maleic acid, gluconic acid, muconic acid, ethylenediaminetetraacetic acid, propylene diaminetetraacetic acid, N,N-bis(carboxymethyl) alanine, nitrilo-triacetic acid, diethylene-triamine-pentaacetic acid, bis(salicyliden)ethylendiamin, aminotris(methylene-phosphonic acid), diethylene-triamine-pentakis(methylphosphonic acid), ethylene-diamine-tetra(methylene-phosphonic acid), or mixtures thereof.

Even more preferably, the at least one stabilizer (F) is selected from ethylenediaminetetraacetic acid, propylene diaminetetraacetic acid, N,N-bis(carboxymethyl) alanine, nitrilo-triacetic acid, diethylene-triamine-pentaacetic acid, bis(salicyliden)ethylendiamin, aminotris(methylenephosphonic acid), diethylene-triamine-pentakis(methylphosphonic acid), ethylene-diamine-tetra(methylene-phosphonic acid), or mixtures thereof.

Most preferably, the at least one stabilizer (F) is ethylenediaminetetraacetic acid.

Preferably, the concentration of the stabilizer (F) is in the range of from ≥ 0.005 wt.% to ≤ 0.15 wt.%, based on the total weight of the composition.

More preferably, the stabilizer (F) is present in an amount of not more than 0.1 wt.%, even more preferably not more than 0.08 wt.%, most preferably not more than 0.03 wt.%, based on the total weight of the composition. The amount of (F) is preferably at least 0.0055 wt.%, more preferably at least 0.006 wt.%, most preferably at least 0.008 wt.%, based on the total weight of the composition. The concentration of the stabilizer (F) is more preferably in the range of from ≥ 0.0055 wt.% to ≤ 0.08 wt.%, most preferably is in the range of from ≥ 0.008 wt.% to ≤ 0.03 wt.%, based on the total weight of the composition.

**(G) Aqueous** medium

According to the presently claimed invention, the composition comprises an aqueous medium (G). The aqueous medium (G) can be of one type or a mixture of different types of aqueous media.

The aqueous medium (G) can preferably be any medium which contains water. Preferably, the aqueous medium (G) is a mixture of water and an organic solvent that is miscible with water. Representative examples of organic solvents include, but are not limited to, $C_1$ to $C_3$ alcohols, alkylene glycols and alkylene glycol derivatives. More preferably, the aqueous medium (G) is water. In a preferred embodiment of the presently claimed invention, the aqueous medium (G) is deionized water.

For the purposes of the presently claimed invention, if the amounts of the components other than (G) are in total y wt.% t of the composition, then the amount of (G) is (100-y) wt.% of the composition.

The amount of the aqueous medium (G) in the composition is preferably not more than 99.9 wt.%, more preferably not more than 99.6 wt.%, most preferably not more than 99 wt.%, particularly preferably not more than 98 wt.%, particularly not more than 97 wt.%, for example not more than 95 wt.%, based on the total weight of the composition. The amount of the aqueous medium (C) in the composition is preferably at least 60 wt.%, more preferably at least 70 wt.%, most preferably at least 80 wt.%, particularly preferably at least 85 wt.%, particularly at least 90 wt.%, for example at least 93 wt.%, based on the total weight of the composition.

The properties of the composition may depend on the pH of the corresponding composition. According to the presently claimed invention, the pH of the composition is in the range of from ≥ 2.0 to ≤ 4.5. Preferably, the pH value of the composition is ≤ 4.3, more preferably ≤ 4.2, most preferably ≤ 4.0, particularly preferably ≤ 3.9, particularly most preferably ≤ 3.5. The pH value of the composition is preferably ≥ 2.1, more preferably ≥ 2.3, most preferably ≥ 2.5, particularly preferably ≥ 2.6, particularly most preferably ≥ 2.8. The pH value of the composition is preferably in the range of from ≥ 2.1 to ≤ 4.3, preferably from ≥2.3 to ≤ 4.2, more preferably from ≥ 2.5 to ≤ 4.0, most preferably from ≥ 2.8 to ≤ 3.5.

The composition further comprises an additive selected from pH adjusting agent, oxidizing agent, wetting agent, dispersing agent, biocide, or mixtures thereof.

The at least one pH adjusting agent is different from the components (A), (B), (C), (D), (E), (F) and (G) and is optionally added in addition to said components.

Preferably, the at least one pH adjusting agent is selected from the group consisting of inorganic acids, carboxylic acids, amine bases, alkali hydroxides, ammonium hydroxides, including tetraalkylammonium hydroxides. Preferably, the at least one pH adjusting agent is selected from the group consisting of nitric acid, sulfuric acid, phosphorous acid, ammonia, sodium hydroxide and potassium hydroxide. More preferably, the pH adjusting agent is potassium hydroxide.

The amount of the at least one pH adjusting agent is preferably not more than 10 wt.%, more preferably not more than 2 wt.%, most preferably not more than 0.5 wt.%, particularly not more than 0.1 wt.%, for example not more than 0.05 wt.%, based on the total weight of the composition. The amount of the at least one pH adjusting agent (E) is preferably at least 0.0005 wt.%, more preferably at least 0.005 wt.%, most preferably at least 0.025 wt.%, particularly at least 0.1 wt.%, for example at least 0.4 wt.%, based on the total weight of the composition.

The composition of the presently claimed invention can further contain at least one oxidizing agent.

Preferably, the at least one oxidizing agent is selected from the group consisting of organic peroxides, inorganic peroxides, nitrates, persulfates, iodates, periodic acids, periodates, permanganates, perchloric acids, perchlorates, bromic acids and bromates. Said oxidizing agent is optionally present in addition to the iron (III) oxidizer.

More preferably, the at least one oxidizing agent is hydrogen peroxide.

Preferably, the at least one oxidizing agent is present in an amount in the range of ≥ 0.01 wt.% to ≤ 1.0 wt.%, based on the total weight of the composition.

Preferably, the concentration of the at least one oxidizing agent is not more than 5.0 wt.%, even more preferably not more than 2.0 wt.%, even more preferably not more than 1.0 wt.%, even more preferably not more than 0.8 wt.%, most preferably not more than 0.5 wt.%, in each case based on the total weight of the composition. The concentration of the at least one oxidizing agent is at preferably atleast 0.01 wt.%, more preferably at least 0.05 wt.%, most preferably at least 0.1 wt.%, in each case based on the total weight of the composition.

More preferably, the concentration of hydrogen peroxide as oxidizing agent is ≥0.01 wt.% to ≤ 1.0 wt.%, even more preferably ≥0.05 wt.% to ≤1.0 wt.%, most preferably ≥0.05 wt.% to ≤0.5 wt.%, particularly preferably ≥0.01 wt.% to ≤0.1 wt.%, in each case based on the total weight of the composition.

The processes for preparation of compositions for inhibition of tungsten etching are generally known. These processes may be applied to the preparation of the composition of the presently claimed invention. This can be carried out by dispersing or dissolving the components described hereinabove (A), (B), (D) and (E) in the aqueous medium (C), preferably water, and optionally by adjusting the pH value through adding an acid, a base, a buffer or a pH adjusting agent (F). For this purpose, the customary and standard mixing processes and mixing apparatuses such as agitated vessels, high shear impellers, ultrasonic mixers, homogenizer nozzles or counter flow mixers, can be used.

A preferred embodiment of the presently claimed invention is directed to a composition comprising the following components:

(A) surface - modified colloidal silica particles comprising a negatively - charged group on the surface of the particles, wherein the surface-modified colloidal silica

particles have a negative charge,
a particle size of from 60 nm to 200 nm, and
a zeta potential < -35 mV at a pH of from ≥ 2.0 to ≤ 4.5;

(B) first corrosion inhibitor selected from at least one guanidine derivative;
(C) second corrosion inhibitor selected from polyacrylamides or polyacrylamide copolymers;
(D) at least one iron (III) oxidizer;
(E) at least one silicon oxide removal rate enhancer selected from phosphoric acid and salts thereof;
(F) at least one stabilizer selected from ethylenediaminetetraacetic acid, propylene diaminetetraacetic acid, N,N-bis(carboxymethyl) alanine, nitrilo-triacetic acid, diethylene-triamine-pentaacetic acid, bis(salicyliden)ethylendiamin, aminotris(methylenephosphonic acid), diethylene-triamine-pentakis(methylphosphonic acid), ethylene-diamine-tetra(methylene-phosphonic acid), or mixtures thereof; and
(G) an aqueous medium,

wherein the pH of the composition is in the range of from ≥ 2.0 to ≤ 4.5.

Another preferred embodiment of the presently claimed invention is directed to a composition comprising the following components:

(A) surface - modified colloidal silica particles comprising a negatively - charged group on the surface of the particles, wherein the surface-modified colloidal silica

particles have a negative charge,
a particle size of from 60 nm to 200 nm,
a zeta potential < -35 mV at a pH of from ≥ 2.0 to ≤ 4.5, and
concentration in the range of from ≥ 0.01 wt.% to ≤ 13.0 wt.%, based on the total weight of the composition;

(B) first corrosion inhibitor selected from at least one guanidine derivative and having concentration in the range of from ≥ 0.005 wt.% to ≤ 0.05 wt.%, based on the total weight of the composition;
(C) second corrosion inhibitor selected from polyacrylamides or polyacrylamide copolymers and having weight average molecular weight of the second corrosion inhibitor (C) is in the range of from ≥ 5000 g/mol to ≤ 50,000 g/mol, determined according to gel permeation chromatography;
(D) at least one iron (III) oxidizer in the range of from ≥ 0.005 wt.% to ≤ 0.1 wt.%, based on the total weight of the

composition;
(E) at least one silicon oxide removal rate enhancer selected from phosphoric acid and salts thereof and having concentration in the range of from ≥ 0. 1 wt.% to ≤ 1.0 wt.%, based on the total weight of the composition;
(F) at least one stabilizer selected from ethylenediaminetetraacetic acid, propylene diaminetetraacetic acid, N,N-bis(carboxymethyl) alanine, nitrilo-triacetic acid, diethylene-triamine-pentaacetic acid, bis(salicyliden)ethylendiamin, aminotris(methylenephosphonic acid), diethylene-triamine-pentakis(methylphosphonic acid), ethylene-diamine-tetra(methylene-phosphonic acid), or mixtures thereof and having concentration in the range of from ≥ 0.005 wt.% to ≤ 0.15 wt.%, based on the total weight of the composition; and
(G) an aqueous medium,

wherein the pH of the composition is in the range of from ≥ 2.0 to ≤ 4.5.

Another preferred embodiment of the presently claimed invention is directed to a composition comprising the following components:

(A) surface - modified colloidal silica particles comprising a negatively - charged group on the surface of the particles, wherein the surface-modified colloidal silica

particles have a negative charge,
a particle size of from 60 nm to 200 nm,
a zeta potential < -35 mV at a pH of from ≥ 2.0 to ≤ 4.5, and
concentration in the range of from ≥ 0.01 wt.% to ≤ 13.0 wt.%, based on the total weight of the composition;

(B) first corrosion inhibitor selected from at least one guanidine derivative and having concentration in the range of from ≥ 0.005 wt.% to ≤ 0.05 wt.%, based on the total weight of the composition;
(C) second corrosion inhibitor selected from polyacrylamides or polyacrylamide copolymers and having concentration in the range of from ≥ 0.005 wt.% to ≤ 0.02 wt.%, based on the total weight of the composition;
(D) at least one iron (III) oxidizer in the range of from ≥ 0.005 wt.% to ≤ 0.1 wt.%, based on the total weight of the composition;
(E) at least one silicon oxide removal rate enhancer selected from phosphoric acid and salts thereof and having concentration in the range of from ≥ 0. 1 wt.% to ≤ 1.0 wt.%, based on the total weight of the composition;
(F) at least one stabilizer selected from ethylenediaminetetraacetic acid, propylene diaminetetraacetic acid, N,N-bis(carboxymethyl) alanine, nitrilo-triacetic acid, diethylene-triamine-pentaacetic acid, bis(salicyliden)ethylendiamin, aminotris(methylenephosphonic acid), diethylene-triamine-pentakis(methylphosphonic acid), ethylene-diamine-tetra(methylene-phosphonic acid), or mixtures thereof and having concentration in the range of from ≥ 0.005 wt.% to ≤ 0.15 wt.%, based on the total weight of the composition; and
(G) an aqueous medium,

wherein the pH of the composition is in the range of from ≥ 2.0 to ≤ 4.5.

Another preferred embodiment of the presently claimed invention is directed to a composition comprising the following components:

(A) surface - modified colloidal silica particles comprising a negatively - charged group on the surface of the particles, wherein the surface-modified colloidal silica

particles have a negative charge,
a particle size of from 60 nm to 200 nm,
a zeta potential < -35 mV at a pH of from ≥ 2.5 to ≤ 4.0, and
concentration in the range of from ≥ 0.3 wt.% to ≤ 7.0 wt.%, based on the total weight of the composition;

(B) first corrosion inhibitor selected from at least one guanidine derivative and having concentration in the range of from ≥ 0.01 wt.% to ≤ 0.03 wt.%, based on the total weight of the composition;
(C) second corrosion inhibitor selected from polyacrylamides or polyacrylamide copolymers and having concentration in the range of from ≥ 0.006 wt.% to ≤ 0.012 wt.%, based on the total weight of the composition;
(D) at least one iron (III) oxidizer in the range of from ≥ 0.008 wt.% to ≤ 0.03 wt.%, based on the total weight of the composition;
(E) at least one silicon oxide removal rate enhancer selected from phosphoric acid and salts thereof and having concentration in the range of from ≥ 0.35 wt.% to ≤ 0.65 wt.%, based on the total weight of the composition;
(F) at least one stabilizer selected from ethylenediaminetetraacetic acid, propylene diaminetetraacetic acid, N,N-bis(carboxymethyl) alanine, nitrilo-triacetic acid, diethylene-triamine-pentaacetic acid, bis(salicyliden)ethylendiamin, aminotris(methylenephosphonic acid), diethylene-triamine-pentakis(methylphosphonic acid), ethylene-diamine-tetra(methylene-phosphonic acid), or mixtures thereof and having concentration in the range of from ≥ 0.008 wt.% to ≤ 0.03 wt.%, based on the total weight of the composition; and

(G) an aqueous medium,

wherein the pH of the composition is in the range of from ≥ 2.5 to ≤ 4.0.

A preferred embodiment of the presently claimed invention is directed to a composition comprising the following components:

(A) surface - modified colloidal silica particles comprising a negatively - charged group on the surface of the particles, wherein the surface-modified colloidal silica

particles have a negative charge,
a particle size of from 60 nm to 200 nm,
a zeta potential < -35 mV at a pH of from ≥ 2.5 to ≤ 4.0, and
concentration in the range of from ≥ 0.3 wt.% to ≤ 7.0 wt.%, based on the total weight of the composition;

(B) first corrosion inhibitor selected from at least one guanidine derivative and having concentration in the range of from ≥ 0.01 wt.% to ≤ 0.03 wt.%, based on the total weight of the composition;

(C) second corrosion inhibitor selected from polyacrylamides or polyacrylamide copolymers and having weight average molecular weight of the second corrosion inhibitor (C) is in the range of from ≥ 7500 g/mol to ≤ 15,000 g/mol, determined according to gel permeation chromatography;

(D) at least one iron (III) oxidizer in the range of from ≥ 0.008 wt.% to ≤ 0.03 wt.%, based on the total weight of the composition;

(E) at least one silicon oxide removal rate enhancer selected from phosphoric acid and salts thereof and having concentration in the range of from ≥ 0.35 wt.% to ≤ 0.65 wt.%, based on the total weight of the composition;

(F) at least one stabilizer selected from ethylenediaminetetraacetic acid, propylene diaminetetraacetic acid, N,N-bis(carboxymethyl) alanine, nitrilo-triacetic acid, diethylene-triamine-pentaacetic acid, bis(salicyliden)ethylendiamin, aminotris(methylenephosphonic acid), diethylene-triamine-pentakis(methylphosphonic acid), ethylene-diamine-tetra(methylene-phosphonic acid), or mixtures thereof and having concentration in the range of from ≥ 0.008 wt.% to ≤ 0.03 wt.%, based on the total weight of the composition; and

(G) an aqueous medium,

wherein the pH of the composition is in the range of from ≥ 2.5 to ≤ 4.0.

Process for the manufacture of a semiconductor device

In another aspect, the presently claimed invention is directed to a process for the manufacture of a semiconductor device comprising the chemical mechanical polishing of a substrate (S) used in the semiconductor industry, substrate (S) comprises

(i) tungsten and/or
(ii) tungsten alloys; and
(iii) at least one dielectric layer selected from silicon, silicon oxide, silicon nitride, or low-k material, in the presence of the composition as described herein.

Preferably, the dielectric layer comprises a combination of silicon oxide and silicon nitride.

Preferably, the ratio of material removal rate (MRR) of silicon oxide to the material removal rate (MRR) of tungsten is in the range of from 2:1 to 100:1. More preferably, the ratio of material removal rate (MRR) of silicon oxide to the material removal rate (MRR) of tungsten is in the range of from 3:1 to 70:1. Even more preferably, the ratio of material removal rate (MRR) of silicon oxide to the material removal rate (MRR) of tungsten is in the range of from 3:1 to 50:1. More preferably, the ratio of material removal rate (MRR) of silicon oxide to the material removal rate (MRR) of tungsten is in the range of from 3:1 to 40:1. Still more preferably, the ratio of material removal rate (MRR) of silicon oxide to the material removal rate (MRR) of tungsten is in the range of from 3:1 to 20:1. Most preferably, the ratio of material removal rate (MRR) of silicon oxide to the material removal rate (MRR) of tungsten is in the range of from 4:1 to 15:1.

Preferably, the ratio of material removal rate (MRR) of silicon nitride to the material removal rate (MRR) of tungsten is in the range from 1.2:1 to 5:1. More preferably, the ratio of material removal rate (MRR) of silicon nitride to the

material removal rate (MRR) of tungsten is in the range from 1.3:1 to 4:1. Even more preferably, the ratio of material removal rate (MRR) of silicon nitride to the material removal rate (MRR) of tungsten is in the range from 1.3:1 to 3.5:1. Most preferably, the ratio of material removal rate (MRR) of silicon nitride to the material removal rate (MRR) of tungsten is in the range from 1.5:1 to 3.0:1.

Preferably, the static etch rate (SER) of tungsten < 20 ppb. More preferably, the static etch rate (SER) of tungsten < 18 ppb. Even more preferably, the static etch rate (SER) of tungsten < 15 ppb. Most preferably, the static etch rate (SER) of tungsten < 12 ppb.

Preferably, the material removal rate (MRR) of silicon oxide is > 100 Å/min. More preferably, the material removal rate (MRR) of silicon oxide is > 150 Å/min. Even more preferably, the material removal rate (MRR) of silicon oxide is > 230 Å/min. Most preferably, the material removal rate (MRR) of silicon oxide is > 320 Å/min.

Preferably, the material removal rate (MRR) of silicon nitride is > 80 Å/min. More preferably, the material removal rate (MRR) of silicon nitride is > 90 Å/min. Most preferably, the material removal rate (MRR) of silicon nitride is > 100 Å/min.

The semiconductor device which can be manufactured by the process according to the presently claimed invention is not particularly limited. The semiconductor devices can be electronic components comprising semiconducting materials, as for example silicon, germanium, and III-V materials. Semiconductor devices can be those which are manufactured as single discrete devices or those which are manufactured as integrated circuits (ICs) consisting of several devices manufactured and interconnected on a wafer. Semiconductor devices can be two terminal devices for example a diode, three terminal devices for example a bipolar transistor, four terminal devices for example a Hall effect sensor or multi-terminal devices. Preferably, the semiconductor device is a multi-terminal device. Multi-terminal devices can be logic devices as integrated circuits and microprocessors or memory devices as random-access memory (RAM), read only memory (ROM) and phase change random access memory (PCRAM). Preferably the semiconductor device is a multi-terminal logic device. In particular, the semiconductor device is an integrated circuit or microprocessor.

Generally, in integrated circuits tungsten (W) is used for copper interconnects. The excess tungsten above the dielectrics, can be removed by the chemical mechanical polishing process known.

Generally, this tungsten/tungsten alloy can be produced or obtained in different ways, such as ALD, PVD or CVD processes. Generally, this tungsten and/or tungsten alloy can be of any type, form, or shape. This tungsten and/or tungsten alloy preferably has the shape of a layer and/or overgrowth. If this tungsten and/or tungsten alloy has the shape of a layer and/or overgrowth, the tungsten and/or tungsten alloy content is preferably more than 90%, more preferably more than 95%, most preferably more than 98%, particularly more than 99%, for example more than 99.9% by weight of the corresponding layer and/or overgrowth. This tungsten and/or tungsten alloy has been preferably filled or grown in trenches or plugs between other substrates, more preferably filled or grown in trenches or plugs in dielectric materials like for example $SiO_2$, silicon, low-k (BD1, BD2) or ultra-low-k materials, or other isolating and semiconducting material used in the semiconductor industry. For example, in the Through Silicon Vias (TSV) middle process insulating materials such as polymers, photoresist and/or polyimide can be used as insulating material between the subsequent processing steps of wet etch and CMP for insulating/isolating properties after revealing the TSV from the backside of the wafer.

Use

In another aspect, the presently claimed invention is directed to the use of a composition described herein for polishing a substrate (S) comprising: (i) tungsten and/or (ii) tungsten alloys; and (iii) at least one dielectric layer.

Preferably, the at least dielectric layer selected from silicon, silicon oxide, silicon nitride, or low-k material. More preferably, the dielectric layer comprises a combination of silicon oxide and silicon nitride.

Preferably, the composition is for use in semiconductor manufacture and processes thereof.

The presently claimed invention is illustrated in more detail by the accompanying figures.

Figure 1 shows influence of pH on zeta potential values of the surface - modified colloidal silica particles, i.e., component (A), i.e., measured by electrophoretic measurement. The colloidal silica particles having two different particle sizes of 75 and 109 nm were investigated.

Figure 2 depicts surface images (obtained by SEM) of substrates polished using compositions. Substrates polished with composition according to the invention comprising anionic colloidal silica particles is shown in Figure 2a, whereas the substrates polished with cationic colloidal silica particles is shown in Figure 2b.

Figure 3 depicts DLS measurement of a filtered silica dispersion measured with a Malvern Zetasizer ZSP when the zeta potential of surface - modified colloidal silica particles is > -35 mV at a pH in the range of from ≥ 2.0 to ≤ 4.5. The measurement indicates the inability of DLS method to record stable measurement when the zeta potential of surface - modified colloidal silica particles is > -35 mV at a pH in the range of from ≥ 2.0 to ≤ 4.5. The zeta potential of silica particles was set at -23 mV at pH 2.8 with 0.1 M potassium chloride for measurements.

Figure 4 depicts DLS measurement of a filtered silica dispersion measured with a Malvern Zetasizer ZSP when the zeta potential of surface - modified colloidal silica particles is < -35 mV at a pH in the range of from ≥ 2.0 to ≤ 4.5.

The composition according to the presently claimed invention has at least one of the following advantages:

(1) The compositions and the methods of the presently claimed invention show a high selectivity for removal of silicon oxide versus tungsten.
(2) The compositions and the methods of the presently claimed invention show an improved performance in inhibition of etching, especially inhibition of etching of tungsten and cobalt (as evidenced by low SER values).
(3) The composition of the presently claimed invention provides a stable formulation or dispersion, wherein no phase separation or agglomeration occurs, especially in the acidic regime.
(4) The composition of the presently claimed invention allows easy processability, such as compatibility towards industrially relevant steps such as microfiltration.
(5) The process of the presently claimed invention is easy to apply and requires as few steps as possible.
(6) The compositions and the methods of the presently claimed invention allows good tunability, thus high silicon oxide ($SiO_2$) and silicon nitride (SiN) removal rates are achievable, while ensuring low tungsten (W) removal rates.
(7) The composition of the presently claimed invention aims to provide suitable removal rates as mentioned above, while preventing unwanted surface defects and ensuring high surface quality.

## Examples

The presently claimed invention is illustrated in detail by the working examples which follow.
More particularly, the test methods specified hereinafter are part of the general disclosure of the application and are not restricted to the specific working examples.
The general procedure for the preparation of the slurry and the experiments is described below.

### Components:

- silica particles commercially available under the tradename Fuso® PLXC (cationic particle) and Fuso® PL5D (anionic particle) available from Fuso Chemical Corporation
- chlorhexidine and chlorhexidine digluconate available from Sigma Aldrich
- deionized water available from BASF SE
- polyacrylamide available from Sigma Aldrich
- hydrogen peroxide available from BASF SE
- guanidine carbonate salt available from Sigma Aldrich
- cetyltrimethylammonium bromide (CTAB ) available from Sigma Aldrich

### Slurry composition:

The slurry composition comprises:

(A) silica particles a particle size of from 60 nm to 200 nm, and a zeta potential < -35 mV at a pH of about 3
(B) first corrosion inhibitor: chlorhexidine digluconate
(C) second corrosion inhibitor: polyacrylamide
(D) an oxidizing agent: iron (III) nitrate
(E) silicon oxide removal rate enhancer: dipotassium hydrogen phosphate; and
(F) deionized water (DIW)

### Methods

### Procedure for preparation of the slurry composition

The components in the slurry composition were thoroughly mixed and all mixing procedures were carried out under stirring. An aqueous stock solution of each compound (A), (B), (C), (D) and (E) was prepared by dissolving the desired amount of the respective compound in ultra-pure water (UPW). For the stock solutions of the components, phosphoric acid ($H_3PO_4$) was preferably used to support dissolution. The pH of the stock solution was adjusted to ~ ~pH

3.9 by KOH. The stock solutions of (B) had a concentration of 20 wt.% chlorhexidine digluconate solution, that of (C) of 0.08 wt.%. For (A) a dispersion was used as provided by the supplier, typically about 20% - 30% abrasive concentration by weight.

The oxidizing agent (D) was used as a buffered iron EDTA salt solution. Said solution was made by mixing iron (III) nitrate (1.0 wt.%), dipotassium hydrogen phosphate (5 wt.%) and $H_4$-EDTA (in slight molar excess to iron) in UPW. Alternatively, the oxidizing gent (D) was used in the form of a Fe(III)EDTA solution obtainable by commonly known methods. For instance, as reported by Lind et. al., Stereochemistry of Ethylenediamintetraacetato Complexes, Inorganic Chemistry Vol. 3, No 1, 1964 (page 34 f*).*

The final composition was passed through a 5 μm syringe filter prior to DLS measurements, as outlined below, or 0.1 μm before CMP. Filtration being an industrially important process, the colloidal stability of the composition is further highlighted by its ability to remain colloidally stable despite microfiltration.

**Inorganic particles (A) used in the Examples**

The examples in accordance with the present invention contained colloidal silica particles (A1) having an average average secondary particle size (d2) of 109 nm (as determined using dynamic light scattering (DLS) techniques via a Malvern Zeta Sizer ZSP instrument). The silica surface has been modified by sulfonic acid moieties.

**Procedure for particle shape characterization**

An aqueous cocoon-shaped silica particle dispersion with 20 wt.% solid content was dispersed on a carbon foil and was dried. The dried dispersion was analyzed by using Energy Filtered-Transmission Electron Microscopy (EF-TEM) (120 kilo volts) and Scanning Electron Microscopy secondary electron image (SEM-SE) (5 kilo volts). The EF-TEM image with a resolution of 2k, 16 Bit, 0.6851 nm/pixel was used for the analysis. The images were binary coded using the threshold after noise suppression. Afterwards the particles were manually separated. Overlying and edge particles were discriminated and not used for the analysis. ECD, shape factor and sphericity as defined before were calculated and statistically classified.

**Measurement of zeta potential**

The zeta potential value was measured with a Malvern Zetasizer ZSP (software version 7.11) equipped with a DTS1070 disposable folded capillary cell. Measurements were recorded at 25 C and 0.1% solids concentration. To ensure same, the sample solution was filtered through Mil-lex SV Low Protein Durapore PVDF Membrane (5 μm). The zeta-potential was calculated from the measured electrokinetic mobility and the particle size, as obtained from the DLS measurements and fitted on Smoluchowski model.

**Measurement of pH**

The pH - value was measured with a pH combination electrode (Schott, blue line 22 pH electrode).

**Measurement of particle size- Dynamic light scattering (DLS)**

Measurement was carried out with a Malvern Zetasizer ZSP equipped with a semi-micro polystyrene cuvette. Measurements were carried out at 25°C by dispersing particles (A) in water (0,1%). Instrument settings: Dispersant: water (visc.: 0,8872 mPa*s; RI 1,330); 5 measurements, each 60s; Automatic attenuator selection yes: measurement position fixed at 4.65; analysis model: General purpose.

Figures 3 and 4 depict DLS measurement of a filtered silica dispersion (based on inventive example 1) measured with a Malvern Zetasizer ZSP when the zeta potential of surface - modified colloidal silica particles is > -35 mV and < -35 mV at a pH in the range of from ≥ 2.0 to ≤ 4.5, respectively. The figure 3 indicates the inability of DLS method to record stable measurement when the zeta potential of surface - modified colloidal silica particles is > -35 mV at a pH in the range of from ≥ 2.0 to ≤ 4.5 (zeta potential adjusted by KCl). On the other hand, stable signal could be recorded when the zeta potential of surface - modified colloidal silica particles is < -35 mV at a pH in the range of from ≥ 2.0 to ≤ 4.5 (refer Figure 4).

**Static Etch Rate (SER) Experiment W**

SER experiments were carried out as the following:

- A tungsten (W) coated wafer was cut into several 2.5x2.5 cm coupons and washed with deionized water (DIW).

- Each coupon was treated with 0.1% citric acid solution for 4 min and then washed with DIW.
- 300ml of freshly prepared slurry was put into a beaker and brought to 60 °C .
- The tungsten (W) coupon was placed into the slurry and kept in the slurry for 10 min. in the SER apparatus.
- The tungsten (W) coupon was removed and rinsed 1 min with DIW and dried with nitrogen.
- The concentration of tungsten ions was measured by ICP-MS in the slurry post etching.

**Static Etch Rate (SER) Experiment Co**

SER experiments were carried on as the following:

- A cobalt (Co) coated wafer was cut into several 2.5x2.5 cm coupons and washed with deionized water (DIW). Each coupon was treated with 0.1% citric acid solution for 4 min and then washed with DIW.
- The tungsten (Co) film thickness ($d_{before}$) was measured with a 4-point probe.
- 300ml of freshly prepared slurry was put into a beaker and brought to 60 °C .
- The cobalt (Co) coupon was placed into the slurry and kept in the slurry for 10 min. in the SER apparatus.
- The cobalt (Co) coupon was removed and rinsed 1 min with DIW and dried with nitrogen.
- The cobalt (Co) film thickness ($d_{after}$) was measured with the same device again.
- The Static Etch Rate (SER) was determined by the following formula:

$$\text{SER (A/min)} = (d_{before} - d_{after})/10$$

**Standard CMP process for 300 mm barrier polishing wafers:**

| | |
|---|---|
| CMP polisher: | 300 mm AMAT Reflexion |
| Slurry flow: | 300 ml/min |
| Down pressure: | 2.0 psi |
| Rotation speed polishing platen: | 123 rpm |
| Rotation speed polishing head: | 117 rpm |
| Polishing pad: | Fujibo H600 |
| Pad conditioning: | 3M disc A189L (commercial product); 3 lb; 6,5 s; (to prevent pad glazing) |

**Surface defect measurement using SEM:**

The surface defects were measured via SEM (Hitachi SU8220). The wafers were polished for 1.0 min, polished and dried prior to inspection.

**Table 1: Composition Examples**

| Function | Chemical Information | Example 1 | Example 2 | Example 3 |
|---|---|---|---|---|
| Abrasive | Silica (surf. mod.) | 6,50% | 2,00% | 2,00% |
| Inhibitor 1 | Chlorhexidine digluconate | 0,02% | 0,02% | 0,02% |
| Inhibitor 2 | Polyacrylamide | 0,008% | 0,008% | 0,008% |
| Stabiliser | $H_4$-EDTA | 0,012% | 0,012% | 0,012% |
| Oxidiser | $Fe(NO_3)_3 \times 9H_2O$ | 0,01% | 0,01% | 0,01% |
| Buffer | $K_2HPO_4$ | 0,50% | 0,50% | 0,50% |
| pH adjustor | $H_3PO_4$ | about 0,3%* | about 0,3%* | about 0,3%* |
| pH | | 4 | 4 | 2,4 |
| *The exact amount of phosphoric acid depends on pH and reactive concentration of surface modified silica raw dispersion. | | | | |

**Table 2: Composition Counter Examples**

| Function | Chem. Information | C1 | C2 | C3 | C4 | C5 | C6 | C7 | C8 | C9 |
|---|---|---|---|---|---|---|---|---|---|---|
| Abrasive | Silica (surf. mod.) | 2,0 | 2,0 | 6,5 | 6,5 | 6,5 | 6,5 | 6,5 | 6,5 | 6,5 |
| Inhibitor 1 | Chlorhexidine digluconate | | | | | | 0,004 | 0,1 | 0,02 | 0,028 |
| Inhibitor 2 | Polyacrylamide | | | | | | 0,001 | 0,6 | 0,008 | |
| Inhibitor 3 | Glycine | | | | 0,16 | 0,16 | | | | |
| Stabiliser | $H_4$-EDTA | 0,012 | 0,012 | 0,012 | 0,012 | 0,012 | 0,012 | 0,012 | 0,018 | 0,012 |
| Oxidiser | $Fe(NO_3)_3$ x $9H_2O$ | 0,01 | 0,01 | 0,01 | 0,01 | 0,01 | 0,01 | 0,01 | 0,015 | 0,01 |
| Buffer | $K_2HPO_4$ | | 0,5 | 0,5 | 0,5 | 0,5 | 0,5 | 0,5 | 0,5 | 0,5 |
| pH adjustor | $H_3PO_4$ | | | | | | | | | |
| pH | | 2,4 | 2,4 | 4 | 4 | 2,4 | 4 | 4 | 4 | 4 |

| Function | Chemical information | C10 |
|---|---|---|
| Abrasive | Cationic Silica (surface mod.) | 2,0% |
| Inhibitor | PEI | 0,02% |
| Stabiliser | Malonic acid | 0,067% |
| Oxidiser | Fe(NO3)3x9H2O | 0,01% |
| Buffer (pH adj.) | H3PO4 | 0,561% |
| pH | | 4 |

**Preparation of Fe(III) oxidizer solution using phosphoric acid as stabilizer (comparative examples C11-C13)**

C11- 20.0 g of ultra pure water (UPW) is taken in a beaker. 0.2 g of 10% phosphoric acid is added followed by 15 g UPW. KOH (1.0 mol/l) is added until pH is about 4 followed by addition of 10 g of UPW. This is followed by addition of 6 g of 1.0% Fe(NO3)3 x $9H_2O$ in UPW and final volume is made upto 100 g.

C12- the procedure as outlined for C11 was followed except that 2.0 g of 10% phosphoric acid was added.

C13- the procedure as outlined for C12 was followed except that 30 g of 1.0% Fe(NO3)3 x $9H_2O$ in UPW was added before making up the volume to 100 g.

**Preparation of Fe(III) oxidizer solution using H4-EDTA as stabilizer (according to examples 1-3)**

20.0 g of UPW is given into a beaker. 5.0 g of K2HPO4 is added and stirred until a clear solution has been achieved. 0.12 g of H4-EDTA (ethylene diamine tetraacetic acid) is added. The mixture is stirred until a clear solution has been achieved. 25 g of UPW are added. Phosphoric acid (10%) is added until pH of about 4 has been reached. 10 g of an Iron-Nitrate solution (1.0%) is added under stirring.

**Results of experiments**

**Table 3**

| | MRR TEOS [A/min] | MRR W [A/min] | MRR LP-SiN [A/min] | SER W [ppb] | SER Co [A/min] | Colloidal stability |
|---|---|---|---|---|---|---|
| Example 1 | 573 | 76 | 137 | 11,2 | 396 | Yes |
| Example 2 | 408 | 39 | 102 | 10,5 | 358 | Yes |
| Example 3 | 358 | 64 | 118 | 8,5 | 432 | Yes |
| C1 | 199 | 70 | 77 | 19,8 | 515 | Yes |

(continued)

| | MRR TEOS [A/min] | MRR W [A/min] | MRR LP-SiN [A/min] | SER W [ppb] | SER Co [A/min] | Colloidal stability |
|---|---|---|---|---|---|---|
| C2 | 436 | 104 | 47 | 21,6 | 623 | Yes |
| C3 | 621 | 136 | 131 | 20,8 | 399 | Yes |
| C4 | 629 | 134 | 141 | 22 | 384 | Yes |
| C5 | 699 | 108 | 159 | 16,8 | 599 | Yes |
| C6 | 598 | 130 | 128 | 13,5 | 301 | Yes |
| C7 | - | - | - | - | - | No |
| C8 | 615 | 269 | 253 | 11,8 | 498 | Yes |

Table 4

| Guanidine derivative | W SER (ppb) |
|---|---|
| Buformin | 18.5 |
| Phenformin | 17.1 |
| Guanine | 23.8 |
| Proguanil hydrochloride | 18.1 |
| 2-Guanidinobenzimidazole | 28.6 |
| Polyhexamethylene Biguanide Hydrochloride | 33.8 |
| Polyaminopropyl Biguanide | 29.5 |

The compositions were prepared according to example 1 by replacing chlorhexidine digluonate with 0.02% of the mentioned guanidine derivative.

**Discussion of results**

Table 1 shows the Static Etching Rate or Static Etch Rate (SER) as well as Material Removal Rates (MRR) of different compositions. Two different concentrations of silica particles (A) were tested (2 wt.% and 6.5 wt.%) in order to ascertain compatibility of components with low (such as seen in ready-to-use formulations) as well as high particle concentration (such as seen in concentrate formulations). The inventive example 1, for instance was found to reveal surprising colloidal stability despite the presence of high silica particle content (6.5 wt.%). The combination of various components (A) to (G) were noted to be critical in providing acceptable polishing efficiency as well as solution stability for inventive examples 1-3. The zeta potentials of unmodified silica particles were found to increase under acidic regime (pH < 7) (refer Figure 1). However, surprisingly, the surface-modified colloidal silica particles were found to maintain consistently low zeta potential (in the range -35 to -60 mV), thus providing colloidal stability even under acidic regime. Substrates polished with composition according to the invention comprising anionic colloidal silica particles (Figure 2a) were found to reveal smooth surface, whereas the cationic colloidal silica particles (Figure 2b) were found to result in agglomerates which are clearly visible on surface of substrate (corresponding to comparative example C10). The addition of chlorhexidine or chlorhexidine digluconate as corrosion inhibitor (B) in combination with polyacrylamide as corrosion inhibitor (C) in the composition provides a SER of tungsten below 12 ppb at the pH ranges provided. It was further noted that the addition of chlorhexidine alone to the composition (comparative example C9) or the absence of components (B) and (C) (comparative examples C1-C5) leads to unwanted effects, such as surface topological defects and low silicon oxide removal rates, respectively. Additionally, preparation of Fe(III) oxidizer solution using phosphoric acid alone as stabilizer (C11-C13) resulted in undesirable precipitation. Preparation of Fe(III) oxidizer solution according to example 1-3 on the other hand provided a clear and amber coloured solution.

The addition of other corrosion inhibitors known in the prior art such as glycine under the same conditions either result in unwanted effects, such as high SER of tungsten (W) or high SER of cobalt (Co). Table 3 also shows the significant impact of pH in the SER of tungsten. Higher pH range results in lower static etch rates of tungsten (W).

Furthermore, a number of guanidine derivatives were tested and as can be seen from the results outlined in Table 4, the compositions comprising these guanidine derivatives also similar results, such as low tungsten (W) SER.

The compositions of the examples according to the presently claimed invention show improved performance of high $SiO_2$ and SiN MRR, low W MRR, low W and Co SER, while having colloidal or high dispersion stability.

## Claims

1. A dielectric polishing composition comprising

   (A) surface - modified colloidal silica particles comprising a negatively - charged group on the surface of the particles, wherein the surface-modified colloidal silica particles have a negative charge,

      a particle size of from 60 nm to 200 nm, as determined using dynamic light scattering technique, and
      a zeta potential < -35 mV at a pH in the range of from ≥ 2.0 to ≤ 4.5, the zeta potential is determined using the method disclosed in the description;

   (B) a first corrosion inhibitor selected from at least one guanidine derivative;
   (C) a second corrosion inhibitor selected from polyacrylamides or polyacrylamide copolymers;
   (D) at least one iron (III) oxidizer;
   (E) at least one silicon oxide removal rate enhancer selected from phosphoric acid and salts thereof;
   (F) at least one stabilizer; and
   (G) an aqueous medium,

   wherein the pH of the composition is in the range of from ≥ 2.0 to ≤ 4.5.

2. The composition according to claim 1, wherein the surface-modified colloidal silica particles have a zeta potential of from -80 mV to -35 mV at a pH in the range of from ≥ 2.0 to ≤ 4.5.

3. The composition according to any of claims 1 to 2, wherein the concentration of the surface - modified colloidal silica particles (A) is in the range of from ≥ 0.01 wt.% to ≤ 13.0 wt.%, based on the total weight of the composition.

4. The composition according to any of claims 1 to 3, wherein the guanidine derivative is selected from buformin, phenformin, guanine, proguanil hydrochloride, 2-guanidinobenzimidazole, polyhexamethylene biguanide hydrochloride, polyaminopropyl biguanide, chlorhexidine or chlorhexidine salts.

5. The composition according to any of claims 1 to 4, wherein the concentration of the first corrosion inhibitor (B) is in the range of from ≥ 0.005 wt.% to ≤ 0.05 wt.%, based on the total weight of the composition.

6. The composition according to any of claims 1 to 5, wherein the wherein the pH of the composition is in the range of from ≥ 2.5 to ≤ 4.0.

7. The composition according to any of claims 1 to 6, wherein the weight average molecular weight of the second corrosion inhibitor (C) is in the range of from ≥ 5000 g/mol to ≤ 50,000 g/mol, determined according to gel permeation chromatography.

8. The composition according to any of claims 1 to 7, wherein the concentration of the second corrosion inhibitor (C) is in the range of from ≥ 0.005 wt.% to ≤ 0.02 wt.%, based on the total weight of the composition.

9. The composition according to any of claims 1 to 8, wherein the iron (III) oxidizer (D) is selected from iron (III) nitrate or hydrates thereof.

10. The composition according to any of claims 1 to 9, wherein the concentration of the iron (III) oxidizer (D) is in the range of from ≥ 0.005 wt.% to ≤ 0.1 wt.%, based on the total weight of the composition.

11. The composition according to any of claims 1 to 10, wherein the concentration of the silicon oxide removal rate enhancer (E) is in the range of from ≥ 0. 1 wt.% to ≤ 1.0 wt.%, based on the total weight of the composition.

12. The composition according to any of claims 1 to 11, wherein the stabilizer (F) is selected from acetic acid, acetylacetonate, o-phosphorylethanolamine, phosphonic acid, alendronic acid, acetic acid, phthalic acid, citric acid,

adipic acid, oxalic acid, malonic acid, aspartic acid, succinic acid, glutaric acid, pimelic acid, suberic acid, azelaic acid, sebacic acid, oxalic acid, maleic acid, gluconic acid, muconic acid, ethylenediaminetetraacetic acid, propylene diaminetetraacetic acid, N,N-bis(carboxymethyl) alanine, nitrilo-triacetic acid, diethylene-triamine-pentaacetic acid, bis(salicyliden)ethylendiamin, aminotris(methylenephosphonic acid), diethylene-triamine-pentakis(methylphosphonic acid), ethylenediamine-tetra(methylene-phosphonic acid), or mixtures thereof.

**13.** The composition according to any of claims 1 to 12, wherein the concentration of the stabilizer (F) is in the range of from ≥ 0.005 wt.% to ≤ 0.15 wt.%, based on the total weight of the composition.

**14.** The composition according to any of claims 1 to 13, wherein composition further comprises an additive selected from pH adjusting agent, oxidizing agent, wetting agent, dispersing agent, biocide, or mixtures thereof.

**15.** The composition according to any of claims 1 to 14, wherein the composition is for polishing a substrate (S) wherein the substrate (S) comprises: (i) tungsten and/or (ii) tungsten alloys; and (iii) at least one dielectric layer selected from silicon, silicon oxide, silicon nitride, or low-k material.

**16.** A process for the manufacture of a semiconductor device comprising the chemical mechanical polishing of a substrate (S) used in the semiconductor industry wherein the substrate (S) comprises

(i) tungsten and/or
(ii) tungsten alloys; and
(iii) at least one dielectric layer selected from silicon, silicon oxide, silicon nitride, or low-k material,

in the presence of a composition as defined in any one of claims 1 to 15.

**17.** The process according to claim 16, wherein the ratio of material removal rate (MRR) of silicon oxide to the material removal rate (MRR) of tungsten is in the range from 2:1 to 100:1.

**18.** The process according to any of claims 16 to 17, wherein the static etch rate (SER) of tungsten is < 20 ppb.

**19.** The process according to any claims 16 to 18, wherein the material removal rate (MRR) of silicon oxide is > 100 Å/min.

**20.** The process according to any claims 16 to 19, wherein the material removal rate (MRR) of silicon nitride is > 80 Å/min.

**21.** Use of the composition according to any of claims 1 to 15 for polishing a substrate (S) comprising: (i) tungsten and/or (ii) tungsten alloys; and (iii) at least one dielectric layer.

**22.** The use according to claim 21, wherein the at least one dielectric is selected from silicon, silicon oxide, silicon nitride, or low-k material.

## Patentansprüche

**1.** Dielektrische Polierzusammensetzung, umfassend

(A) oberflächenmodifizierte kolloidale Siliciumdioxidpartikel, die eine negativ geladene Gruppe auf der Oberfläche der Partikel umfassen, wobei die oberflächenmodifizierten kolloidalen Siliciumdioxidpartikel eine negative Ladung aufweisen,

eine Teilchengröße von 60 nm bis 200 nm, bestimmt mittels dynamischer Lichtstreuungstechnik, und
ein Zetapotential < -35 mV bei einem pH-Wert im Bereich von ≥ 2,0 bis ≤ 4,5, wobei das Zetapotential mittels des in der Beschreibung offenbarten Verfahrens bestimmt wird,

(B) einen ersten Korrosionsinhibitor, ausgewählt aus mindestens einem Guanidinderivat,
(C) einen zweiten Korrosionsinhibitor, ausgewählt aus Polyacrylamiden oder Polyacrylamidcopolymeren,
(D) mindestens ein Eisen(III)-Oxidationsmittel,
(E) mindestens einen Siliciumoxid-Entfernungsbeschleuniger, ausgewählt aus Phosphorsäure und Salzen davon,

(F) mindestens einen Stabilisator und
(G) ein wässriges Medium,

wobei der pH-Wert der Zusammensetzung im Bereich von ≥ 2,0 bis ≤ 4,5 liegt.

**2.** Zusammensetzung nach Anspruch 1, wobei die oberflächenmodifizierten kolloidalen Siliciumdioxidpartikel ein Zetapotential von -80 mV bis -35 mV bei einem pH-Wert im Bereich von ≥ 2,0 bis ≤ 4,5 aufweisen.

**3.** Zusammensetzung nach Anspruch 1 oder 2, wobei die Konzentration der oberflächenmodifizierten kolloidalen Siliciumdioxidpartikel (A) im Bereich von ≥ 0,01 Gew.-% bis ≤ 13,0 Gew.-%, bezogen auf das Gesamtgewicht der Zusammensetzung, liegt.

**4.** Zusammensetzung nach einem der Ansprüche 1 bis 3, wobei das Guanidinderivat aus Buformin, Phenformin, Guanin, Proguanilhydrochlorid, 2-Guanidinobenzimidazol, Polyhexamethylenbiguanidhydrochlorid, Polyaminopropylbiguanid, Chlorhexidin oder Chlorhexidinsalzen ausgewählt ist.

**5.** Zusammensetzung nach einem der Ansprüche 1 bis 4, wobei die Konzentration des ersten Korrosionsinhibitors (B) im Bereich von ≥ 0,005 Gew.-% bis ≤ 0,05 Gew.-%, bezogen auf das Gesamtgewicht der Zusammensetzung, liegt.

**6.** Zusammensetzung nach einem der Ansprüche 1 bis 5, wobei der pH-Wert der Zusammensetzung im Bereich von ≥ 2,5 bis ≤ 4,0 liegt.

**7.** Zusammensetzung nach einem der Ansprüche 1 bis 6, wobei das gewichtsmittlere Molekulargewicht des zweiten Korrosionsinhibitors (C) im Bereich von ≥ 5000 g/mol bis ≤ 50.000 g/mol, bestimmt mittels Gelpermeationschromatographie, liegt.

**8.** Zusammensetzung nach einem der Ansprüche 1 bis 7, wobei die Konzentration des zweiten Korrosionsinhibitors (C) im Bereich von ≥ 0,005 Gew.-% bis ≤ 0,02 Gew.-%, bezogen auf das Gesamtgewicht der Zusammensetzung, liegt.

**9.** Zusammensetzung nach einem der Ansprüche 1 bis 8, wobei das Eisen(III)-Oxidationsmittel (D) aus Eisen(III)-nitrat oder Hydraten davon ausgewählt ist.

**10.** Zusammensetzung nach einem der Ansprüche 1 bis 9, wobei die Konzentration des Eisen(III)-Oxidationsmittels (D) im Bereich von ≥ 0,005 Gew.-% bis ≤ 0,1 Gew.-%, bezogen auf das Gesamtgewicht der Zusammensetzung, liegt.

**11.** Zusammensetzung nach Anspruch 1 oder 10, wobei die Konzentration des Siliciumoxid-Entfernungsbeschleunigers (E) im Bereich von ≥ 0,1 Gew.-% bis ≤ 1,0 Gew.-%, bezogen auf das Gesamtgewicht der Zusammensetzung, liegt.

**12.** Zusammensetzung nach einem der Ansprüche 1 bis 11, wobei der Stabilisator (F) aus Essigsäure, Acetylacetonat, o-Phosphorylethanolamin, Phosphonsäure, Alendronsäure, Essigsäure, Phthalsäure, Citronensäure, Adipinsäure, Oxalsäure, Malonsäure, Asparaginsäure, Bernsteinsäure, Glutarsäure, Pimelinsäure, Korksäure, Azelainsäure, Sebacinsäure, Oxalsäure, Maleinsäure, Gluconsäure, Muconsäure, Ethylendiamintetraessigsäure, Propylendiamintetraessigsäure, N,N-Bis(carboxymethyl)alanin, Nitrilotriessigsäure, Diethylentriaminpentaessigsäure, Bis(salicyliden)ethylendiamin, Aminotris(methylenphosphonsäure), Diethylentriaminpentakis(methylphosphonsäure), Ethylendiamintetra(methylenphosphonsäure) oder Mischungen davon ausgewählt ist.

**13.** Zusammensetzung nach einem der Ansprüche 1 bis 12, wobei die Konzentration des Stabilisators (F) im Bereich von ≥ 0,005 Gew.-% bis ≤ 0,15 Gew.-%, bezogen auf das Gesamtgewicht der Zusammensetzung, liegt.

**14.** Zusammensetzung nach einem der Ansprüche 1 bis 13, wobei die Zusammensetzung weiterhin ein aus Mitteln zum Einstellen des pH-Wertes, Oxidationsmitteln, Netzmitteln, Dispergiermitteln, Bioziden oder Mischungen davon ausgewähltes Additiv umfasst.

**15.** Zusammensetzung nach einem der Ansprüche 1 bis 14, wobei die Zusammensetzung zum Polieren eines Substrats (S) dient, wobei das Substrat (S) Folgendes umfasst: (i) Wolfram und/oder (ii) Wolframlegierungen und (iii) mindestens eine aus Silicium, Siliciumoxid, Siliciumnitrid oder Low-k-Materialien ausgewählte dielektrische Schicht.

**16.** Verfahren zur Herstellung einer Halbleitervorrichtung, umfassend das chemischmechanische Polieren eines in der

Halbleiterindustrie verwendeten Substrats (S), wobei das Substrat (S) Folgendes umfasst

(i) Wolfram und/oder
(ii) Wolframlegierungen und
(iii) mindestens eine aus Silicium, Siliciumoxid, Siliciumnitrid oder Low-k-Materialien ausgewählte dielektrische Schicht,

in Gegenwart einer wie in einem der Ansprüche 1 bis 15 definierten Zusammensetzung.

**17.** Verfahren nach Anspruch 16, wobei das Verhältnis der Materialentfernungsrate (Material Removal Rate, MRR) von Siliciumoxid zu der Materialentfernungsrate (MRR) von Wolfram im Bereich von 2:1 bis 100:1 liegt.

**18.** Verfahren nach einem der Ansprüche 16 bis 17, wobei die statische Ätzrate (Static Etch Rate, SER) von Wolfram < 20 ppb beträgt.

**19.** Verfahren nach einem der Ansprüche 16 bis 18, wobei die Materialentfernungsrate (MRR) von Siliciumoxid > 100 Å/min beträgt.

**20.** Verfahren nach einem der Ansprüche 16 bis 19, wobei die Materialentfernungsrate (MRR) von Siliciumnitrid > 80 Å/min beträgt.

**21.** Verwendung der Zusammensetzung nach einem der Ansprüche 1 bis 15 zum Polieren eines Substrats (S), umfassend: (i) Wolfram und/oder (ii) Wolframlegierungen und (iii) mindestens eine dielektrische Schicht.

**22.** Verwendung nach Anspruch 21, wobei das mindestens eine Dielektrikum aus Silicium, Siliciumoxid, Siliciumnitrid oder Low-k-Materialien ausgewählt ist.

## Revendications

**1.** Composition de polissage de diélectrique comprenant

(A) des particules de silice colloïdale modifiées en surface comprenant un groupe négativement chargé sur la surface des particules, les particules de silice colloïdale modifiées en surface possédant une charge négative,

une taille de particules de 60 nm à 200 nm, telle que déterminée à l'aide d'une technique de diffusion dynamique de lumière, et
un potentiel zêta < -35 mV à un pH dans la plage de ≥ 2,0 à ≤ 4,5, le potentiel zêta est déterminé en utilisant le procédé divulgué dans la description ;

(B) un premier inhibiteur de corrosion sélectionné parmi au moins un dérivé de guanidine;
(C) un second inhibiteur de corrosion choisi parmi des polyacrylamides ou des copolymères de polyacrylamide ;
(D) au moins un oxydant à base de fer (III) ;
(E) au moins un améliorateur de vitesse d'élimination d'oxyde de silicium choisi parmi l'acide phosphorique et ses sels ;
(F) au moins un stabilisant ; et
(G) un milieu aqueux,

dans laquelle le pH de la composition est dans la plage de ≥ 2,0 à ≤ 4,5.

**2.** Composition selon la revendication 1, dans laquelle les particules de silice colloïdale modifiées en surface ont un potentiel zêta de -80 mV à -35 mV à un pH dans la plage de ≥ 2,0 à ≤ 4,5.

**3.** Composition selon l'une quelconque des revendications 1 et 2, dans laquelle la concentration des particules de silice colloïdale modifiées en surface (A) se situe dans la plage de ≥ 0,01 % en poids à ≤ 13,0 % en poids, sur la base du poids total de la composition.

**4.** Composition selon l'une quelconque des revendications 1 à 3, dans laquelle le dérivé de guanidine est choisi parmi la

buformine, la phénformine, la guanine, le chlorhydrate de proguanil, le 2-guanidinobenzimidazole, le chlorhydrate de polyhexaméthylène biguanide, l'aminopropyl biguanide, la chlorhexidine ou des sels de chlorhexidine.

5. Composition selon l'une quelconque des revendications 1 à 4, dans laquelle la concentration du premier inhibiteur de corrosion (B) est dans la plage de ≥ 0,005 % en poids à ≤ 0,05 % en poids, sur la base du poids total de la composition.

6. Composition selon l'une quelconque des revendications 1 à 5, dans laquelle le pH de la composition est dans la plage de ≥ 2,5 à ≤ 4,0.

7. Composition selon l'une quelconque des revendications 1 à 6, dans laquelle le poids moléculaire moyen en poids du second inhibiteur de corrosion (C) est dans la plage de ≥ 5 000 g/mole à ≤ 50 000 g/mole, déterminé par chromatographie à perméation de gel.

8. Composition selon l'une quelconque des revendications 1 à 7, dans laquelle la concentration du second inhibiteur de corrosion (C) est dans la plage de ≥ 0,005 % en poids à ≤ 0,02 % en poids, sur la base du poids total de la composition.

9. Composition selon l'une quelconque des revendications 1 à 8, dans laquelle l'oxydant à base de fer (III) (D) est choisi parmi le nitrate de fer (III) ou ses hydrates.

10. Composition selon l'une quelconque des revendications 1 à 9, dans laquelle la concentration de l'oxydant à base de fer (III) (D) est dans la plage de ≥ 0,005 % en poids à ≤ 0,1 % en poids, sur la base du poids total de la composition.

11. Composition selon l'une quelconque des revendications 1 à 10, dans laquelle la concentration de l'améliorateur de vitesse d'élimination d'oxyde de silicium (E) est dans la plage de ≥ 0,1 % en poids à ≤ 1,0 % en poids, sur la base du poids total de la composition.

12. Composition selon l'une quelconque des revendications 1 à 11, dans laquelle le stabilisant (F) est choisi parmi acide acétique, acétylacétonate, o-phosphoryléthanolamine, acide phosphonique, acide alendronique, acide acétique, acide phtalique, acide citrique, acide adipique, acide oxalique, acide malonique, acide aspartique, acide succinique, acide glutarique, acide pimélique, acide subérique, acide azélaïque, acide sébacique, acide oxalique, acide maléique, acide gluconique, acide muconique, acide éthylènediaminetétraacétique, acide propylènediaminetétraacétique, N,N-bis(carboxyméthyl)alanine, acide nitrilo-triacétique, acide diéthylène-triamine-pentaacétique, bis(salicylidène)éthylènediamine, acide aminotris(méthylènephosphonique), acide diéthylène-triamine-pentakis(méthylphosphonique), acide éthylènediamine-tétra(méthylènephosphonique), ou leurs mélanges.

13. Composition selon l'une quelconque des revendications 1 à 12, dans laquelle la concentration du stabilisant (F) est dans la plage de ≥ 0,005 % en poids à ≤ 0,15 % en poids, sur la base du poids total de la composition.

14. Composition selon l'une quelconque des revendications 1 à 13, dans laquelle la composition comprend en outre un additif choisi parmi un agent d'ajustement du pH, un agent oxydant, un agent mouillant, un agent dispersant, un biocide, ou leurs mélanges.

15. Composition selon l'une quelconque des revendications 1 à 14, la composition étant pour le polissage d'un substrat (S), le substrat (S) comprenant : (i) du tungstène et/ou (ii) des alliages de tungstène ; et (iii) au moins une couche diélectrique choisie parmi le silicium, l'oxyde de silicium, le nitrure de silicium ou un matériau à bas k.

16. Procédé de fabrication d'un dispositif semiconducteur comprenant le polissage mécano-chimique d'un substrat (S) utilisé dans l'industrie des semiconducteurs, le substrat (S) comprenant

(i) du tungstène et/ou
(ii) des alliages de tungstène ; et
(iii) au moins une couche diélectrique choisie parmi le silicium, l'oxyde de silicium, le nitrure de silicium ou un matériau à bas k,

en la présence d'une composition telle que définie dans l'une quelconque des revendications 1 à 15.

17. Procédé selon la revendication 16, dans lequel le rapport de la vitesse d'élimination de matière (MRR) d'oxyde de silicium sur la vitesse d'élimination de matière (MRR) du tungstène est dans la plage de 2:1 à 100:1.

**18.** Procédé selon l'une quelconque des revendications 16 à 17, dans lequel la vitesse de gravure statique (SER) du tungstène est < 20 ppb.

**19.** Procédé selon l'une quelconque des revendications 16 à 18, dans lequel la vitesse d'élimination de matière (MRR) de l'oxyde de silicium est > 100 Å/min.

**20.** Procédé selon l'une quelconque des revendications 16 à 19, dans lequel la vitesse d'élimination de matière (MRR) du nitrure de silicium est > 80 Å/min.

**21.** Utilisation de la composition selon l'une quelconque des revendications 1 à 15 pour le polissage d'un substrat (S) comprenant : (i) du tungstène et/ou (ii) des alliages de tungstène ; et (iii) au moins une couche diélectrique.

**22.** Utilisation selon la revendication 21, dans laquelle l'au moins un diélectrique est choisi parmi le silicium, l'oxyde de silicium, le nitrure de silicium ou un matériau à bas k.

Figures

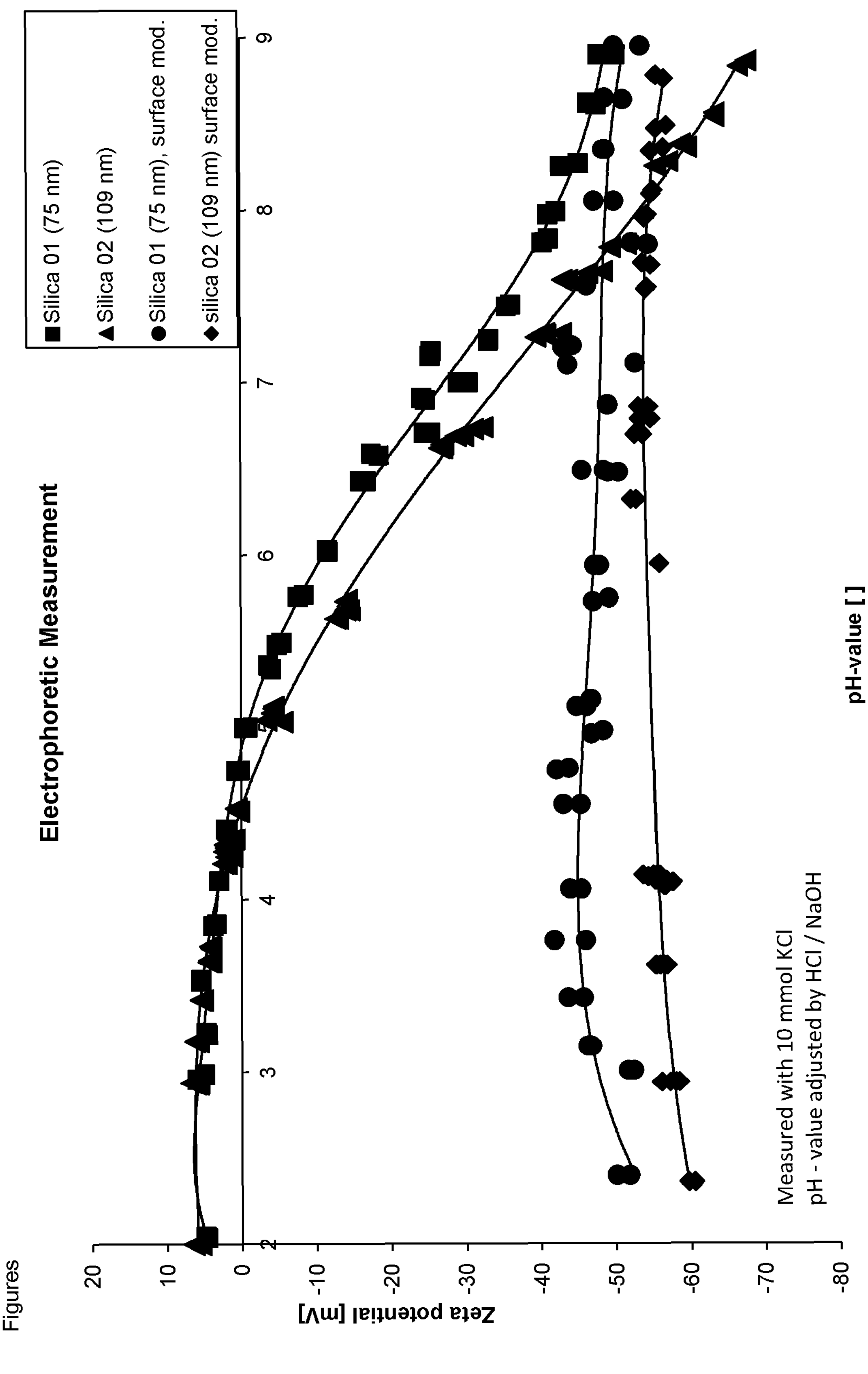


Figure 1

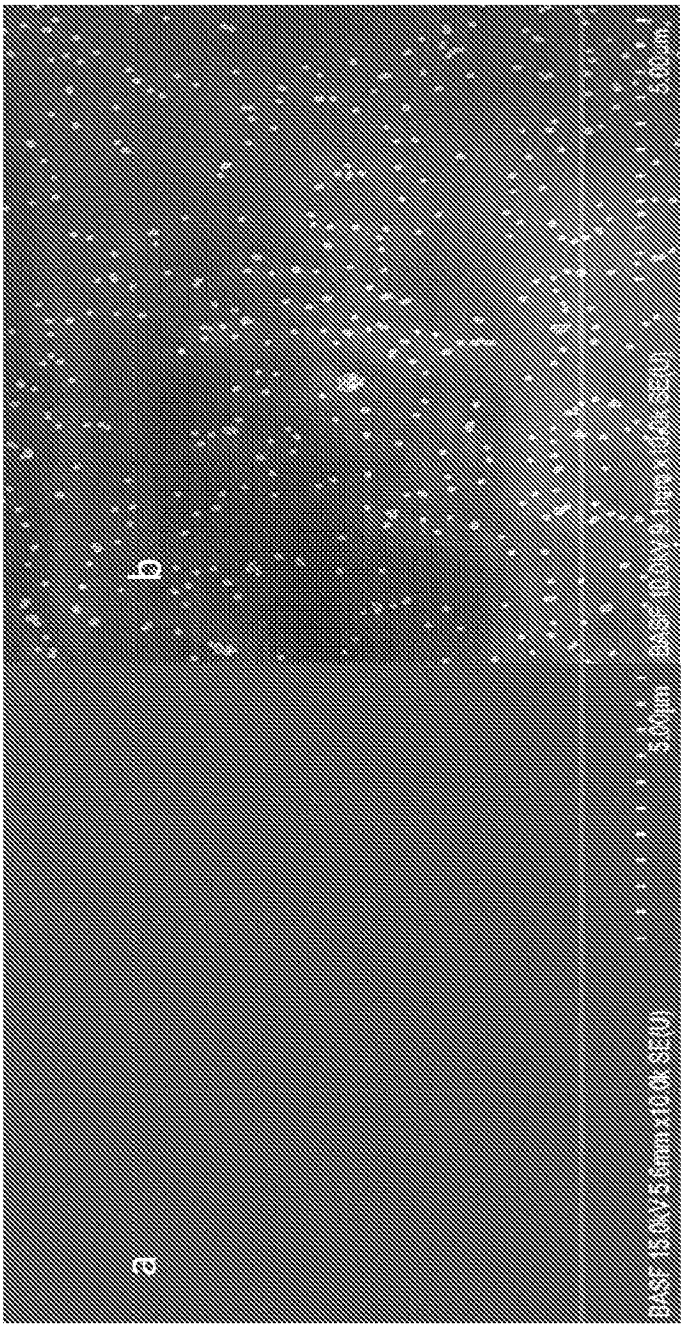


Figure 2

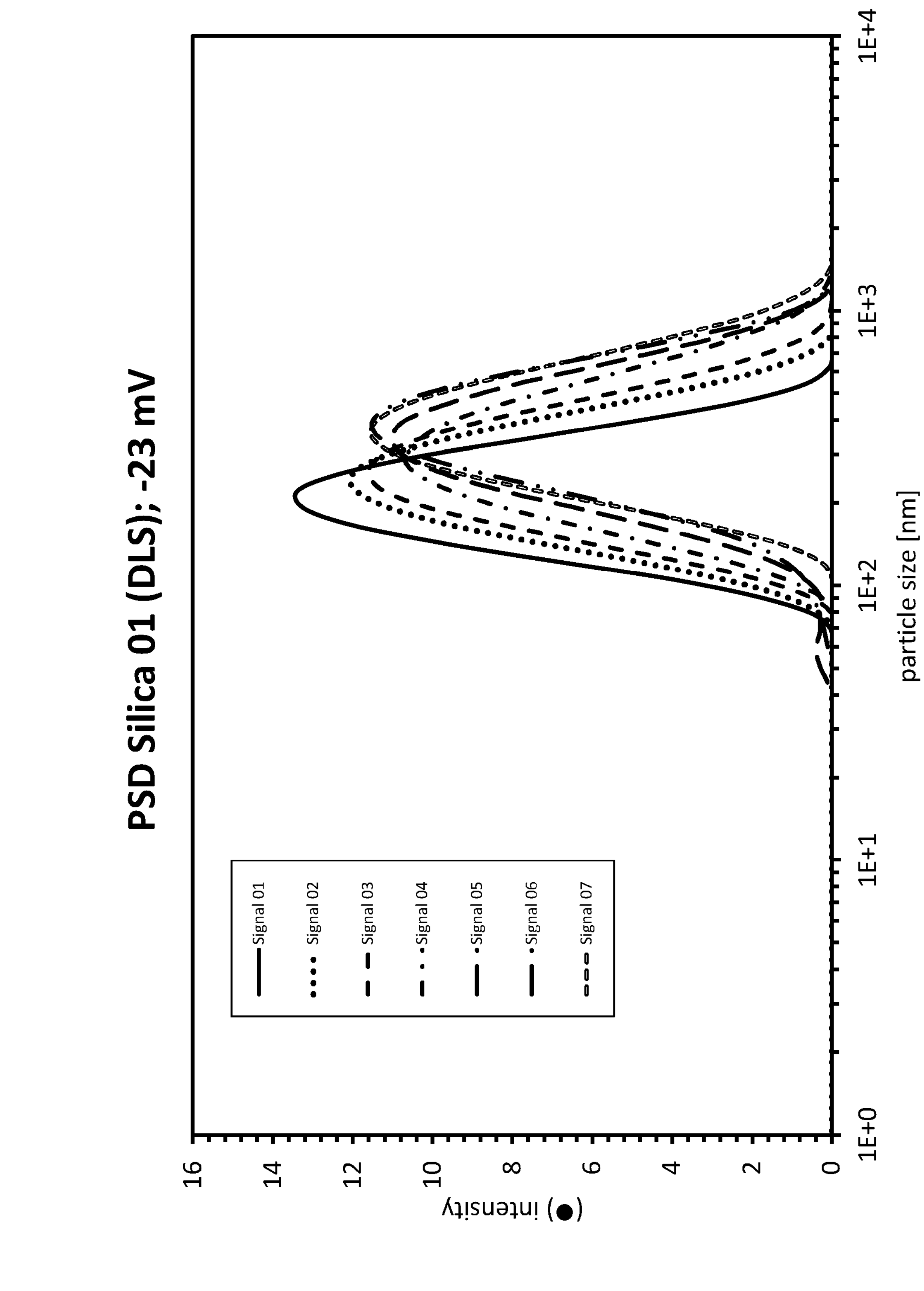
PSD Silica 01 (DLS); -23 mV
(●) intensity
16
14
12
10
8
6
4
2
0
1E+0
1E+1
1E+2
1E+3
1E+4
particle size [nm]
Signal 01
Signal 02
Signal 03
Signal 04
Signal 05
Signal 06
Signal 07

Figure 3

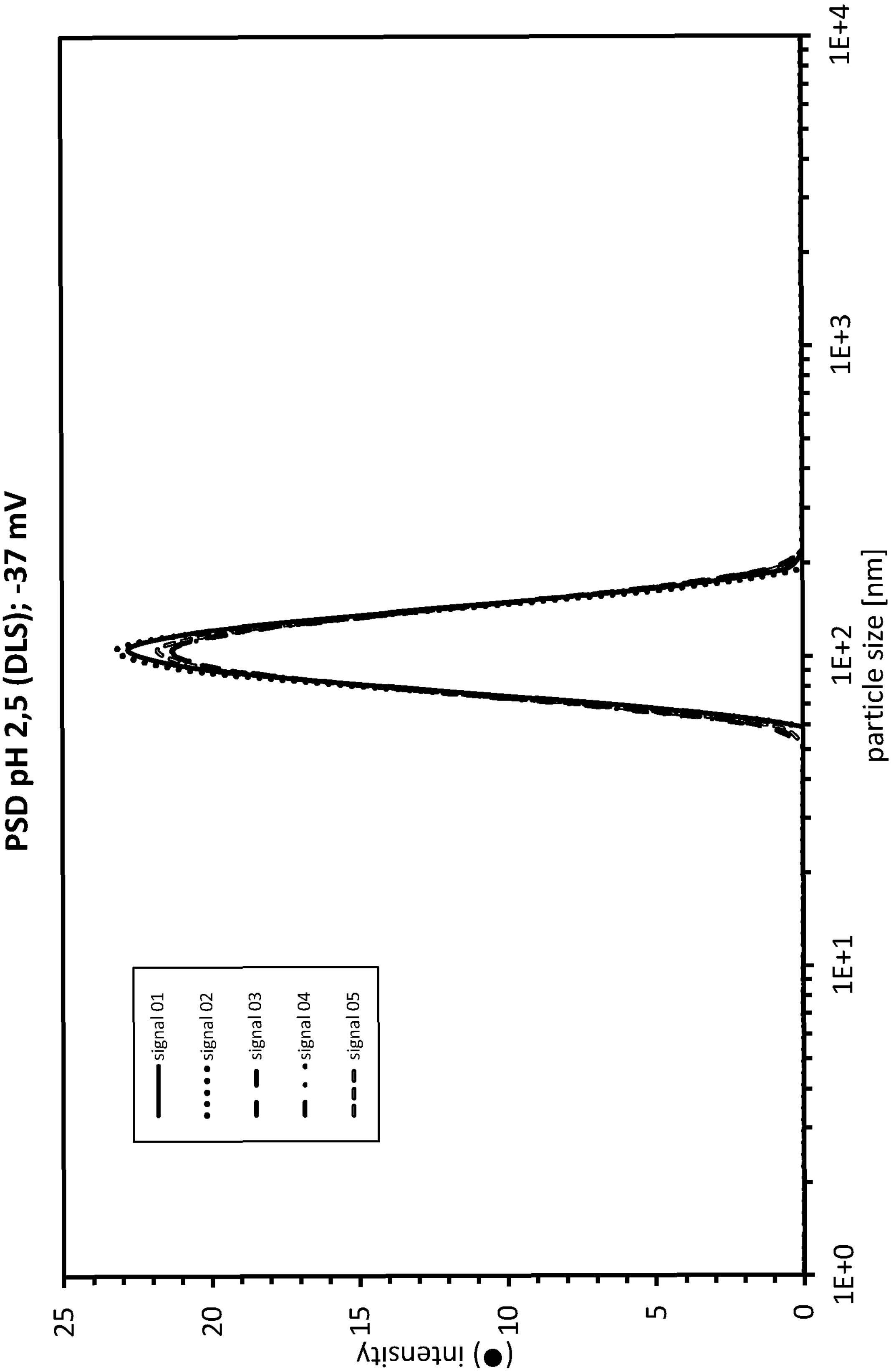
PSD pH 2,5 (DLS); -37 mV
signal 01
signal 02
signal 03
signal 04
signal 05
(●) intensity
25
20
15
10
5
0
1E+0
1E+1
1E+2
1E+3
1E+4
particle size [nm]

Figure 4

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 6083419 A
- US 20190211227 A
- US 20190211228 A
- US 8492277 B
- US 8513126 B
- US 6974777 B2
- US 5230833 A
- WO 2006028759 A2
- WO 20067028759 A2
- WO 2010734542 A1


### Non-patent literature cited in the description


- **HOSALI**. Analyzing damage from ultralow-k CMP. *Solid State Technology*, 2005, vol. 48 (11), 33
- **MCCLATCHIE**. Low Dielectric Constant Oxide Films Deposited Using CVD Techniques. *DUMIC Conference Proceedings*, 1998, 311
- **KUNTZSCH, TIMO** ; **WITNIK, ULRIKE** ; **HOLLATZ, MICHAEL STINTZ** ; **RIPPERGER, SIEGFRIED**. Characterization of Slurries Used for Chemical-Mechanical Polishing (CMP) in the Semiconductor Industry. *Chem. Eng. Technol*, 2003, vol. 12, 1235
- **ESUMI**. *Bull.Chem.Soc.Jpn.*, 1988, vol. 61
- **LIND**. *Stereochemistry of Ethylenediamintetraacetato Complexes, Inorganic Chemistry*, 1964, vol. 3 (1), 34